(19) Europäisches Patentamt
European Patent Office
Office européen des brevets

(11) **EP 4 287 277 B1**

(12) **EUROPEAN PATENT SPECIFICATION**

(45) Date of publication and mention
of the grant of the patent:
**16.10.2024  Bulletin 2024/42**

(21) Application number: **22465538.1**

(22) Date of filing: **02.06.2022**

(51) International Patent Classification (IPC):
*H01L 31/108* (2006.01)   *H01L 31/0216* (2014.01)
*H01L 31/0224* (2006.01)   *H01L 31/18* (2006.01)

(52) Cooperative Patent Classification (CPC):
**H01L 31/022408; H01L 31/02161; H01L 31/1085;
H01L 31/1864**

(54) **RECONFIGURABLE PLASMONIC PHOTODETECTOR AND FABRICATION METHOD**

REKONFIGURIERBARER PLASMONISCHER FOTODETEKTOR UND
HERSTELLUNGSVERFAHREN

PHOTODÉTECTEUR PLASMONIQUE RECONFIGURABLE ET PROCÉDÉ DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**06.12.2023  Bulletin 2023/49**

(73) Proprietors:
• **SC Nanom Mems Srl
505400 Rasnov, jud Brasov (RO)**
• **Cantabria University
39005 Santander (ES)**
• **CNR-Nanotec
70126 Bari (IT)**
• **Tyndall National Institute
T12 R5CP Cork (IE)**

(72) Inventors:
• **COBIANU, Cornel
051434 Bucharest (RO)**
• **GHEORGHE, Marin
505400 Rasnov, jud. Brasov (RO)**
• **SANTOS PERODIA, Gonzalo
39011 Santander (ES)**
• **MORENO GRACIA, Fernando
39005 Santander (ES)**
• **MODREANU, Mircea
Cork (IE)**
• **GUTIERREZ, Yael Vela
39007 Santander (ES)**
• **LOSURDO, Maria
70126 Bari (IT)**

(74) Representative: **Fierascu, Cosmina-Catrinel
Rominvent SA
35 Ermil Pangratti Street
Sector 1
011882  Bucharest (RO)**

(56) References cited:
**US-A- 5 625 729**

• **WANG JING ET AL: "Two-dimensional antimony
selenide (Sb2Se3) nanosheets prepared by
hydrothermal method for visible-light
photodetectors", SOLAR ENERGY, ELSEVIER,
AMSTERDAM, NL, vol. 233, 23 January 2022
(2022-01-23), pages 213 - 220, XP086953677,
ISSN: 0038-092X, [retrieved on 20220123], DOI:
10.1016/J.SOLENER.2022.01.019**
• **SAJJAD ABDOLLAHRAMEZANI ET AL: "Tunable
nanophotonics enabled by chalcogenide
phase-change materials", ARXIV.ORG,
CORNELL UNIVERSITY LIBRARY, 201 OLIN
LIBRARY CORNELL UNIVERSITY ITHACA, NY
14853, 17 January 2020 (2020-01-17),
XP081879107, DOI: 10.1515/NANOPH-2020-0039**
• **JACEK GOSCINIAK: "Waveguide-integrated
plasmonic photodetectors and activation
function units with phase change materials",
ARXIV.ORG, CORNELL UNIVERSITY LIBRARY,
201 OLIN LIBRARY CORNELL UNIVERSITY
ITHACA, NY 14853, 28 September 2021
(2021-09-28), XP091060059**

## Description

Technical field

Embodiments are related to a radically new design and fabrication concept of plasmonic photodetectors for near-infrared (NIR) and visible spectrum, by exploiting the change of optical properties in the reversible optical phase-change-materials (ROPCM) chalcogenides like, $Sb_2S_3$, $Sb_2Se_3$, and their ternary composites $Sb_2S_xSe_{3-x}$, when repeatedly switching from amorphous to (poly)crystalline structural state. Exemplary embodiments are related to reconfigurable plasmonic interdigitated Schottky photodetectors able to perform hopping between different NIR telecom wavelength bands or different colors from the visible (VIZ) spectrum when the chalcogenide active ROPCM material is switched between amorphous to polycrystalline state and the opposite. Moreover, other embodiments show that depending on application requirement, for a specific interdigitated design of the plasmonic interdigitated Schottky photodetectors one can obtain an ultrawideband multi-polarization detection of NIR or VIZ electromagnetic radiation.

## BACKGROUND OF THE INVENTION

The reversible optical phase-change materials (ROPCM) present a major variation in the optical and electrical properties (like complex refractive index, $n'=n-j * k$, where $j=(-1)^{1/2}$ and energy bandgap, Eg) when they are switched from the amorphous phase to the (poly)crystalline phase. The variation of the refractive index ($\Delta n$) and the extinction coefficient ($\Delta k$), (identified as the real and imaginary part of the complex refractive index) related to structural state (amorphous or polycrystalline) is called optical contrast. The variation of the electrical resistivity as a function of structural state is called electrical contrast. The optical and electrical contrasts in ROPCM materials are basically explained by a change in the nature of atomic bonding configuration as a result of the phase transition. (B. Huang and J. Robertson, Bonding origin of optical contrast in phase-change memory materials, PHYSICAL REVIEW B 81, 081204 (R), 2010). This structural transition of the ROPCM materials from amorphous to crystalline state can be performed either by Joule effect via resistive heating or optically by laser irradiation. Synthetically, the optical contrast due to phase transition is represented by a figure of merit (FOM) which has the expression $FOM=\Delta n/\Delta k$, where n is the refractive index (real part of complex refractive index) and k is the extinction coefficient (imaginary part of complex refractive index). From physics point of view, FOM is related to both variation in the dielectric polarizability of the material ($\Delta n$) and the radiation absorption properties ($\Delta k$) of the material as a function of structural state. It is well known that both refractive index, n, and extinction coefficient, k, vary with the wavelength of the incident radiation.

The representative type of materials with optical and electrical contrast due to structural phase transition is the chalcogenide family (compounds containing sulfur, selenium or tellurium, but excluding oxygen). At this stage, the best understood and already industrially-exploited chalcogenide material is $Ge_2Sb_2Te_5$ (GST), which can be switched millions of times from amorphous to (poly)crystalline and back to amorphous state, with low energy consumption for performing these fast structural phase transitions, while it does not need any energy for preserving either amorphous or crystalline state. Such structural behavior of GST where the energy is necessary only for doing a transition, but not for maintaining the polycrystalline or the amorphous phase determines the non-volatility of the GST. In the same time, the fact that the constant optical contrast between amorphous and polycrystalline state is preserved after such a great number of repeated transitions demonstrates GST's reversibility. The phase transition proceeds as follows. If, for example, the initial state of the GST alloy after its preparation is amorphous, then by heating it at about 100-150°C, it will become polycrystalline. For performing its reversible transition from polycrystalline to amorphous transitions, GST should be further heated to the melting point of about 600°C followed by a rapid cooling (quenching), so that the atoms have no time to re-arrange in the crystalline state, and thus the amorphous state is obtained, due to this quenching. (T. Ohta, Phase-Change Optical Memory Promotes The DVD Optical Disk, Journal of Optoelectronics and Advanced Materials Vol. 3, No. 3, September 2001, p. 609 - 626).

These ROPCM materials have an increasing number of photonic applications, in different stages of development. An example of industrial application of GST is its use as optical recording media, which is already a mature commercial technology in the field of high-density optical memories. (Pengfei Guo, Andrew M. Sarangan and Imad Agha, A Review of Germanium-Antimony-Telluride Phase Change Materials for Non-Volatile Memories and Optical Modulators, Appl. Sci. 2019, 9, 530; doi:10.3390/app9030530). The working principle is obtained from the major difference in the reflectivity of GST material as a function of amorphous or polycrystalline state, which will thus define the "0" or "1" digital states for these optical memories. On the other hand, the electrical contrast of GST, demonstrated by a major decrease in the electrical resistivity of GST, of about five orders of magnitude (from about $10^2$ Q*m to about $10^{-3}$ Q*m) when switching from (poly)crystalline to amorphous state, has generated an emerging technology for next generation of electronic non-volatile memories, where the high resistivity versus low resistivity will define the "1" state versus "0" states for digital memories (Pengfei Guo, Andrew M. Sarangan and Imad Agha, A Review of Germanium-Antimony-Telluride Phase Change Materials for Non-Volatile Memories and Optical Modulators, Appl. Sci. 2019, 9, 530;

doi:10.3390/app9030530).

The controlled reversibility of the optical properties of GST as a result of reversible structural phase transitions *and* its associated optical contrast in refractive index and extinction coefficient have opened the avenue towards a new field of applications called reconfigurable photonics, where the optical contrast allows reconfiguring of multiple functionalities. For example, considering the optical contrast of GST in the mid-infrared one can obtain a non-volatile reconfigurable mid-infrared band pass filter with a peak of 72.6% for the narrow band reflection spectrum centered on 3.197 $\mu$m for the amorphous GST and a peak of 25.8 % centered on 4.795 $\mu$m when GST is in the polycrystalline state. In the same time, the reflection spectrum could be tuned in between those values when the crystallization fraction, m, increased from m=0.1 to m=1. ( Xingzhe Shi, Changshui Chen, Songhao Liu , and Guangyuan Li, Nonvolatile, reconfigurable and narrowband mid-infrared filter based on surface lattice resonance in phase-change GeSbTe, Nanomaterials 2020, 10, 2530; doi:10.3390/nano10122530.)

Other examples of reconfigurable photonic devices have been described in the literature, e.g. reconfigurable light modulators (Koba, I.M. *High-resolution Spatial Light Modulator for 3-dimensional Holographic Display.* US Patent 6819469, 16 November 2004), optical switches (Gholipour, B.; Zhang, J.; MacDonald, K.F.; Hewak, D.W.; Zheludev, N.I. An all-optical, non-volatile, bidirectional, phase-change meta-switch. Adv. Mater. 2013, 25, 3050-3054), optical limiters (Sarangan, A.; Duran, J.; Vasilyev, V.; Limberopoulos, N.; Vitebskiy, I.; Anisimov, I. Broadband Reflective Optical Limiter Using GST Phase Change Material. IEEE Photonics J. 2018, 10, 1-9), or polarizing reflectors (Sieber, P.E.; Werner, D.H. Reconfigurable broadband infrared circularly polarizing reflectors based on phase changing birefringent metasurfaces. Opt. Express 2013, 21, 1087-1100).

However, despite the successful use of GST in optical memory applications, there are issues of $Ge_2Sb_2Te_5$ related to the high value of the absorption in the telecom wavelength band (1.26-1.675) $\mu$m (k=1.49 for polycrystalline state and k=0.12 for amorphous phase) (Yael Gutierrez, Anna P. Ovvyan, Gonzalo Santos, Dilson Juan, Saul A. Rosales, Javier Junquera, Pablo Garcia Fernandez, Stefano Dicorato, Maria M. Giangregorio, Elena Dilonardo, Fabio Palumbo, Mircea Modreanu, Josef, Resl, Olga Ishcheko, Guy Garry, Tigers Jouzi, Marin Gheorghe, Cornel Cobianu, Kurt Hingerl, Christoph Cobet, Fernando Moreno, Wolfram H. P. Pernice and Maria Losurdo, Interlaboratory Study Unveiling the Correlation between Structure and Dielectric Function of Sb2S3 and its Amorphous-to-Crystalline Phase Change and Potential Applications, ISCIENCE-D, to be published, 2022) and also related to the coupling of refractive index contrast ($\Delta$n) to the extinction coefficient contrast ($\Delta$k), which limits the performances of some applications, as in the case of light modulators (Yifei Zhang, Jeffrey B. Chou, Junying Li, Huashan Li, Qingyang Du, Anupama Yadav, Si Zhou, Mikhail Y. Shalaginov, Zhuoran Fang, Huikai Zhong, Christopher Roberts, Paul Robinson, Bridget Bohlin, Carlos Ríos, Hongtao Lin, Myungkoo Kang, Tian Gu1, Jamie Warner, Vladimir Liberman, Kathleen Richardson and Juejun Hu, Broadband transparent optical phase change materials for high-performance nonvolatile photonics, NATURE COMMUNICATIONS | (2019) 10:4279 | https://doi.org/10.1038/s41467-019-12196-4 | www.nature.com/naturecommunications. Another major limitation of the GST is its rather low band gap (0.5 eV in the (poly)crystalline state and 0.7 eV in the amorphous state), Agostino Pirovano, Andrea L. Lacaita, Augusto Benvenuti, Fabio Pellizzer, and Roberto Bezwhich, Electronic Switching in Phase-Change Memories, IEEE TRANSACTIONS ON ELECTRON DEVICES, VOL. 51, NO. 3, MARCH 2004), which implies an absorption edge of 1.77 $\mu$m, with higher absorption in the visible range, which will limit again many reconfigurable applications in the visible range.

Under these circumstances, there has been an increasing interest in exploring the optical and electronic properties of other ROPCM chalcogenide semiconducting materials focusing in the same time on identifying those with increasing bandgap above 1 eV and with high optical contrast, which may also allow optical amplitude and phase modulation in the visible range. (Müller, M.J., Yadav, A., Persch, C., Wahl, S., Hoff, F., Wuttig, M., 2021. Tailoring Crystallization Kinetics Chalcogenides for Photonic Applications. Adv. Electron. Mater. 2100974. https://doi.org/10.1002/aelm.202100974). Thus, it was shown that by replacing the tellurium with sulfur the bandgap of the chalcogenide obtained increased and reached a value of 1.7 eV for $Sb_2S_3$ in the amorphous state and about 2.2 eV in the (poly)crystalline state. (Dong, W., Liu, H., Behera, J.K., Lu, L., Ng, R.J.H., Sreekanth, K.V., Zhou, X., Yang, J.K.W., Simpson, R.E., 2019. Wide Bandgap Phase Change Material Tuned Visible Photonics. Adv. Funct. Mater. 29, 1806181.)

The interest in the study of wider bandgap semiconducting chalcogenides as OPCM materials was much increased after the recent excellent demonstration of Dong et al . (Dong, W., Liu, H., Behera, J.K., Lu, L., Ng, R.J.H., Sreekanth, K.V., Zhou, X., Yang, J.K.W., Simpson, R.E., 2019. Wide Bandgap Phase Change Material Tuned Visible Photonics. Adv. Funct. Mater. 29, 1806181.), who proved that the $Sb_2S_3$ thin films presented reversible, non-volatile phase transitions from amorphous to crystalline state (and back to amorphous) by a specific thermal annealing sequence. Thus, contrary to previous belief from the end of the years 1990's (P. Arun, A. Vedeshwar, N. Mehra, Laser-induced crystallization in amorphous films of Sb2C3 (C = S, Se, Te), potential optical storage media, J. Phys. D. Appl. Phys. 1999) , where it was said that $Sb_2S_3$ material can be used only for "writing once and reading many times (WORM)", (i.e., in other words, one cannot have reversible structural phase transitions in $Sb_2S_3$ from crystalline state to amorphous state), the recent work of Dong et al. has shown that an amorphous $Sb_2S_3$ can be switched to a (poly)crystalline state if heated at a temperature higher than 200°C, and then for a back transition to the amorphous state the film has to be heated above its meting temperature (528°C) followed by a rapid cooling (quenching), so as the crystallization to be avoided. These results were later confirmed by more systematic results on cyclability of the $Sb_2S_3$ phase transition, where only a limited decay between 1 and 5% in reflectivity was found after 2000 cycles of phase change. (Delaney, M., Zeimpekis, I., Lawson, D., Hewak, D.W., Muskens, O.L., 2020. A New Family of Ultralow Loss Reversible Phase-Change Materials for Photonic Integrated Circuits: Sb2 S3 and Sb2Se3. Adv. Funct. Mater. 30, 2002447. https://doi.org/10.1002/adfm.202002447). However, Delaney et al. show that these results of good optical contrast stability between amorphous and crystalline state, in $Sb_2S_3$ and $Sb_2Se_3$ were obtained only for the case of using a capping layer of the binary composite of ZnS:SiO$_2$=20:80 above the chalcogenide semiconductor layer, so that to avoid sulfur or selenium atom loss, and thus to preserve the $Sb_2S_3$ and $Sb_2Se_3$ stoichiometry during thermal/laser annealing. In the absence of the capping layer, the laser annealings for the crystallization process and the amorphization are accompanied by the decrease of the sulphur or selenium concentration, due to loss of these atoms from the film, by the formation of their oxides which evaporate in the ambient. Therefore, the reconfigurable devices disclosed in the present invention will contain this capping layer, which is transparent to the radiation in visible and infrared spectrum, acting in the same time as an anti-reflection coating, due to its intermediate refractive index between the air and semiconducting chalcogenide layer (David V. Tsu and Takeo Ohta, Mechanism of properties of noble ZnZ-SiO2 protection layer for phase change optical disk media, Jpn. J. Appl. Phys., 2006, vol. 45, pp 6294).

The $Sb_2S_3$ films have been already used in the past as active absorbing layer in the research of photosensitive devices, like solar cells (Sarah Messina, M.T.S Nair, and K. Nair, Antimony sulfide thin films in chemically deposited thin film photovoltaic cells, Thin Solid Films, 515 (2007) 5777-5782), while the emerging field of optical phase change chalcogenide materials has further increased the interest for a systematic investigation of the optical and electronic film properties as a function of preparation route and thermal annealing. Thus, recently, the authors of this invention have used the chemical bath deposition method (CBD) for preparation of the $Sb_2S_3$ films and they also experimentally studied the associated structural, compositional and optical properties were theoretically and (Cobianu, C., Gheorghe, M., Modreanu, M., Gutierrez, Y., Losurdo, M., 2021 Chemically Bath Deposited Sb2S3, Films as Optical Phase Change Materials, in: 2021 International Semiconductor Conference (CAS). IEEE pp. 249-252. https://doi.org/10.1109/CAS52836.2021.9604155, Gutierrez, Y., Fernández, A., Rosales, S., Cobianu, C., Gheorghe, M., Modreanu, M., Saiz, J., Moreno, F., Losurdo, M., 2022. Polarimetry Analysis and Optical Contrast of Sb2S3 Phase Change Material. Opt. Materials Express, Vol. 12, No. 4 / 1 Apr 2022, pp. 1531-1541) https://doi.org/10.1364/OME.450781, ) performing in the same time a detailed comparison of the optical properties (dielectric function, refractive index, extinction coefficient, optical contrast, FOM) of the $Sb_2S_3$ CBD films with those obtained by other preparation methods, like sputerring (Dong, W., Liu, H., Behera, J.K., Lu, L., Ng, R.J.H., Sreekanth, K.V., Zhou, X., Yang, J.K.W., Simpson, R.E., 2019. Wide Bandgap Phase Change Material Tuned Visible Photonics. Adv. Funct. Mater. 29, 1806181, Delaney, M., Zeimpekis, I., Lawson, D., Hewak, D.W., Muskens, O.L., 2020. A New Family of Ultralow Loss Reversible Phase-Change Materials for Photonic Integrated Circuits: Sb2 S3 and Sb2Se3. Adv. Funct. Mater. 30, 2002447. https://doi.org/10.1002/adfm.202002447, Yael Gutierrez, Anna P. Ovvyan, Gonzalo Santos, Dilson Juan, Saul A. Rosales, Javier Junquera, Pablo Garcia Fernandez, Stefano Dicorato, Maria M. Giangregorio, Elena Dilonardo, Fabio Palumbo, Mircea Modreanu, Josef, Resl, Olga Ishcheko, Guy Garry, Tigers Jouzi, Marin Gheorghe, Cornel Cobianu, Kurt Hingerl, Christoph Cobet, Fernando Moreno, Wolfram H. P. Pernice and Maria Losurdo, Interlaboratory Study Unveiling the Correlation between Structure and Dielectric Function of Sb2S3 and its Amorphous-to-Crystalline Phase Change and Potential Applications, ISCIENCE-D, to be published, 2022), or electrophoretic deposition. Definitely, the optical properties are fingerprinted by the different $Sb_2S_3$ film deposition methods, and this variation can be explained by the nature of each deposition process. For example, it may be intuitively explained that in the case of sputtering deposition process a higher gravimetric density of the film may be obtained in comparison with CBD method, and thus a higher refractive of the film would be expected, which is actually the case. However, the shape of overall dependence of the refractive index, n, and its contrast ($\Delta$n) as a function of incident photon energy is similar for different preparation methods. Moreover, even if there are some small differences in the value of the bandgap energy obtained for different $Sb_2S_3$ deposition methods used, which will obviously affect the evolution of the extinction coefficient, k, and its contrast, $\Delta$k for incident photon energy close to bandgap, in all cases, the, the k value and its contrast is almost equal to zero in the telecom wavelength range (1.26-1.675) $\mu$m, and this will make even impossible to define a conventional FOM value, which is a major atribute of this wideband chalcogenide semiconductor in the telecom photonic applications. On the other hand, the expected high k value in the visible range (with photon energy higher than the bandgap) may be useful in the visible range for photodetectors and solar cell-based energy harvesting applications, even if the optical contrast of extinction coefficient, $\Delta$k may have a lower value (below 1 for photon energy equl to 3 eV) (Yael Gutierrez, Anna P. Ovvyan, Gonzalo Santos, Dilson Juan, Saul A. Rosales, Javier Junquera, Pablo Garcia Fernandez, Stefano Dicorato, Maria M. Giangregorio, Elena Dilonardo, Fabio Palumbo, Mircea Modreanu, Josef, Resl, Olga Ishcheko, Guy Garry, Tigers Jouzi, Marin Gheorghe, Cornel Cobianu, Kurt Hingerl, Christoph Cobet, Fernando Moreno, Wolfram H. P. Pernice and Maria Losurdo, Interlaboratory Study Unveiling the Correlation between Structure and Dielectric Function of Sb2S3 and its Amorphous-to-Crystalline Phase Change and Potential Applications, ISCIENCE-D, to be published, 2022).

Recently, Delaney et al (Delaney, M., Zeimpekis, I., Lawson, D., Hewak, D.W., Muskens, O.L., 2020. A New Family of Ultralow Loss Reversible Phase-Change Materials for Photonic Integrated Circuits: Sb2S3 and Sb2Se3. Adv. Funct. Mater. 30, 2002447) have demonstrated that the antimony selenide ( $Sb_2Se_3$ ) is another (binary) chalcogenide which entered the family of the reversible optical phase change materials (ROPCM), showing an excellent stability of the optical contrast of the refractive index ($\Delta n=0.77$) in the telecom C band at 1.550 $\mu$m after more than 4000 optical transitions between amorphous state and polycrystalline state. The phase transition from amorphous to (poly)crystalline state occured at about 200°C and it was performed by laser radiation with wavelength of 638 nm, with a power of about 45 mW applied for 100 ms . The amorphization was made by a 638 nm laser pulse, with laser power density of 1.5 W/cm2, for about 400 ns. Like in the case of $Sb_2S_3$, the conventional figure of merit (FOM=$\Delta n/\Delta k$)) of $Sb_2Se_3$ cannot even be defined, as the extinction coefficient is equal to zero in the telecom wavelength range, for both amorphous and crystalline state. These low absorption losses can be benefic for a large family of wave-guided programmable integrated photonic circuits. The bandgap energy of $Sb_2Se_3$ depends on the deposition method and structural phase, and it can be in the range of (1.2-1.5) eV, which means that this material can work as an excellent visible light absorber, and this explains its use in the solar cell and visible light photodetector. (Jing Wang, Sajid UrRehman,Yang Xu, Binzhou Zuo, Haohang Cheng, Lingshan Guo, Bin Zou, Xiaoming Zhang, Chuanbo Li, Two-dimensional antimony selenide (Sb2Se3) nanosheets prepared by hydrothermal method for visible-light photodetectors, Solar Energy, Volume 233, February 2022, Pages 213-220). Based on the latest discovery related to reversibility of the structural phase change in $Sb_2Se_3$, the present inventions demonstrates that this material can be used for the realization of the reconfigurable plasmonic photodetectos, too.

The present invention is disclosing radically-new concepts of reconfigurable photonic devices, like reconfigurable plasmonic photodetectors for telecom wavelength band (1.26-1.675) $\mu$m based on semiconducting chalcogenide like $Sb_2S_3$, $Sb_2Se_3$ and their ternary composites like $Sb_2S_xSe_{3-x}$. As a background of this invention, the fundamentals of the surface plasmon enhanced photonic devices will be briefly described, firstly, followed by the prior art in this field of plasmonic photoconductive optoelectronic devices, and intelectual property review.

In any plasmonic device, the interaction between the free-space or guided-wave light and the solid-state matter may generate surface plasmon polaritons (SPP) at the interface between a metal and a dielectric, which should be understood simultaneously as decaying light surface waves propagating along that interface, as well as collective oscillations of the surface electrons of the metal resonating with the incoming light. However, as the momentum of the surface plasmon polaritons ($\hbar$*$k_{SPP}$ where $\hbar$ is the reduced Planck constant and $k_{spp}$ is the propagation wave vector of the SPP) is higher than that of the incident light ($\hbar$* $k_o$; where $k_o=\omega/c=2\pi/\lambda$ is the magnitude of the wave vector of incident light in free space), the SPP generation is possible only in the presence of a topological defect like a metal grating whose momentum ($\hbar$* $k_\Lambda$) is added to the momentum of incident light for matching the SPP momentum. For our invention, a metal grating consisting of a multitude of parallel metal digits with a certain periodicity will be used for momentum conservation law. The grating momentum is defined as a vector with the direction perpendicular to the parallel-oriented metal digits and a magnitude equal to $k_\lambda=2*\pi/\Lambda$. On the other hand, this momentum matching is possible only for transversal magnetic (TM) incident light, characterized by its magnetic field vector perpendicular on the propagation direction and the electric field vector ($E_L$) located in the incidence plan (p-polarized light). Therefore, upfront, one can notice that the generation of SPP is selective to the propagation mode of the light. If the incident light is doing an angle $\theta$ with the direction normal to the grating surface, then the momentum conservation law becomes as written below:

$$k_{spp}=k_o*\sin(\theta)+m* k_\Lambda$$
[1]

where m is an integer number corresponding to the diffraction order of the indent light. The explicit formula of the propagation constant, $k_{spp}$, of the SPP's is written below:

$$k_{spp}= (\omega/c) * \sqrt[2]{(\varepsilon m * \varepsilon d)/(\varepsilon m + \varepsilon d)}$$

[2]

In equation [2], $k_{SPP}$ is a real number (the real part of the SPP propagation wavevector), $\varepsilon m$ is the real part of dielectric permittivity of the metal (which is a negative number) and $\varepsilon d$ is the (real part) dielectric permittivity of the dielectric material in contact with the metal, both parameters being wavelength dependent. From equation [2] it is very easy to note that $k_{SPP}$ is a real number only if the summation of $\varepsilon m$ and $\varepsilon d$ is a negative number! (C. Genet and T.W. Ebessen, Light in tiny holes, Nature Reviews, vol. 445, 4 January 2007). Under these considerations, and assuming that the SPP propagation wave vector, the vector of the electric field of the light projected on the device surface and the grating vector are all colinear, then the explicit scalar formula of the momentum conservation becomes:

$$(\omega/c) * \sqrt[2]{(\varepsilon m * \varepsilon d)/(\varepsilon m + \varepsilon d)} = (\omega/c)*\sin(\theta)+m*2\pi*(1/\Lambda)$$

[3]

From equation [3] one can calculate the value of the grating period ($\Lambda$) which will assure the momentum conservation and the generation of the surface plasmon polaritons at the interface between a metal and a dielectric, when the electric field vector is parallel with the grating vector. In the most general case, when there is a polarization angle, $\delta \neq 0$, between the electric field vector of **p-polarized** light ($\mathbf{E_L}$) and the grating vector, the equation [3] for momentum matching becomes:

$$(\omega/c) * \sqrt[2]{(\varepsilon m * \varepsilon d)/(\varepsilon m + \varepsilon d)} = (\omega/c)*\sin(\theta)*\cos(\delta)+m*2\pi*(1/\Lambda)$$

[4]

Therefore, from equation [4] one can understand that the generation of SPP is selective to light propagation mode (TM only will produce SPP's), wavelength of incident light, polarization angle, and incidence angle, and this is one of the fingerprints of the plasmonic devices.

It is important to note that in the case of incident light perpendicular to the surface of plasmonic device one obtains $\sin(\theta)=0$, and thus only the grating momentum will be used for momentum matching and the associated generation of the surface plasmon polariton. In this later case of $\theta=0$, according to equation [4], the polarization angle, $\delta$, does not affect the resonance wavelength and grating period value, but the projected value of electric field along the grating vector will reduce the component of electric field on that direction by multiplying it with $\cos(\delta)$. Therefore, the resonance short-circuit photocurrent (Isc) of a grating-based plasmonic photodetector, which is proportional to the square of the electric field of **p-polarized** light becomes (intensity of the light) becomes: (M. Jestl, I. Maran A.Kock,

W. Beinstingl and E. Gornik, Polarization sensitive surface plasmon Schottky detectors, Optics Letters, vol.14, No. 14, 15 July 1989, , pp. 719-721):

$$Isc=Isc\ (background)+Isc^{SPP}\ (\ \delta=0)*\cos^2(\delta)$$

[5]

From equation [5] one can notice that for $\delta=90°$, the enhanced plasmonic component of photocurrent is cancelled, even if the **p-polarized** light is used, and thus the polarization angle selectivity of the plasmonic photocurrent is proven.

The above selectivity properties of the plasmonic devices can be benefic for some photonic applications where narrowband response is needed, while for the case of the wideband response applications this is may create more challenges. In this invention, the authors present innovative solutions for increasing the bandwidth of the plasmonic devices and for minimizing the limitations introduced by the polarization angle of the incident light with respect to the grating vector.

Another important basic aspect of the plasmonic devices is that depending of the period of the metal grating, the surface plasmon generation at the interface between a metal and a solid-state isolator, or metal-air, or even between a metal and semiconductor (when fulfilling the above requirement that the summation of the dielectric permittivity of the two materials is a negative number) can be performed. Therefore, SPP generation can be obtained at each of the two interfaces of a metal (either upper interface between metal and air or at the lower interface between the metal and the solid-state dielectric or semiconductor), but grating period is different for these two cases.

By doing calculation of the grating period for each type of interface (metal-air or metal-dielectric) it is easily obtained that the period of grating $\Lambda$ for the metal-solid state dielectric is much smaller with respect to metal-air interface, due to differences in the dielectric permittivity, $\varepsilon d$, of air versus that of the solid-state material. Actually, in the case that $|\varepsilon m|>>\varepsilon d$, from equation [3] one can obtain that the grating period is proportional to $(1/\varepsilon d)$, which explains the much lower value of $\Lambda$ (deep sub-wavelength device) for the SPP generation at the metal-solid state dielectric interface with respect to SPP generation at the metal-air interface.

The analytical modeling of the SPP generation in the plasmonic photodetectors disclosed in this invention is based on equation [3], and it is aiming at the calculation of the period of the grating as a function of the incident wavelength, while the values of the dielectric permittivity of the metal, $\varepsilon m$ and of dielectric, $\varepsilon d$, at each incident wavelength are taken from the literature data. As an example, one can consult the site https://refractiveindex.info/?shelf=3d&book=metals&page=aluminium for an exhaustive description of the dispersion of the optical properties of different types of materials.

The interest for plasmonic devices is coming from the "extraordinary optical transmission" of the light through such sub-wavelength spacing regions of the grating (T.W. Ebbesen, H.J.Lezec, H.F. Ghaemi, T. Thio and P.A. Wolff, Extraordinary optical transmission through sub-wavelength hole array, Nature, vol. 391, 12 February 1998, pp. 667-669), beyond the limit imposed by diffraction, as initially considered by Bethe theory (Beth H.A. Theory of diffraction by small holes, Phys. Rev. 66, (1946), pp. 163-182). Such extraordinary transmission due to SPP generation and propagation through small slits means that for the case of this invention the flux of photons through the interdigit spacing is higher than the incident flux per (metal free) area unit, i.e., the efficiency of light transmission is higher than 1. Such an increased light transmission is driving an enhanced evanescent electromagnetic field perpendicular on the interface between the metal and dielectric and which is decaying in both media, as it was experimentally measured by scanning near-field optical *microscopy* (*SNOM*). (C. Genet and T.W. Ebbesen, Light in tiny holes, Nature Reviews, vol. 445, 4 January 2007, doi.10.1038/nature05350). It is this evanescent field enhancement at the interface which will be exploited in the present invention for the increase of the electric field at the interface between metal and semiconductor in the chalcogenide semiconducting devices for the increase of photocurrents and spectral responsivity in the metal-semiconductor-metal (MSM) photodetectors.

As a result of this extraordinary optical transmission, the light absorption inside the photonic device is increased around the incident wavelength for which the SPP can be generated, and this result can be experimentally proven by the simultaneous narrowband decrease in the spectrum of the reflected light from the surface of the device, accompanied by an increase of the "resonant absorption" in the plasmonic device at that "resonance" wavelength, which is finally followed by the increase of the photocurrent and spectral responsivity, as it is in the case of photodetectors (S.R.J. Brueck, V. Diadiuk, T. Jones and W. Lenth, Enhanced quantum efficiency internal photoemission detectors by grating coupling to the surface plasma waves, Appl. Phys. Letters, vol. 46, (10), 15 may 1985, pp. 915-917, Ali Sobhani, et al, Narrow band photodetection in the near-infrared with a plasmon-induced hot electron device, Nature Communications, 2013, DOI:10.1038/ncomms 2642).

The numerical modeling and simulation of the subwavelength plasmonic devices can offer a much more complete description of the SPP generation process and photonic device operation with respect to analytical modelling described above. Thus, for a specific layout of the structure, with known optical properties of materials, geometry and thickness of the metal digits of the grating, the commercial simulation tools are providing not only the value of the grating periodicity, but also the distribution of the enhanced evanescent electric and magnetic field at the interface between upper metal-air interface and lower metal-dielectric interface, the resonant wavelength for absorption and reflection of the incident light, as well as the effect of the metal thickness on these phenomena. The absorption results described in the present invention are obtained by the Rigorous Coupled Wave Analysis (RCWA) method, which is a semi-analytical method in computational electromagnetics that is typically employed to solve diffraction of a field by a given periodic grating structure. The fields are represented by a sum of spatial harmonics, since RCWA is a Fourier-space method. In a uniform layer the spatial harmonics correspond to the well-known plane waves. The method is based on Floquet's theorem, which states that the solutions of periodic differential equations can be expanded in Floquet functions.

As the present invention is disclosing a radically new concept of reconfigurable plasmonic photodetectors, based on phase-change $Sb_2S_3$ chalcogenide semiconductor and interdigitated metal-semiconductor-metal (MSM) hot electrons Schottky devices for telecom wavelengths (1.26-1.675) $\mu m$, in this paragraph, the background of the hot electrons Schottky devices is briefly described. Hot electrons plasmonic Schottky photodetectors for telecom wavelength band are well known in the art. For example, in the reference (S.R.J. Brueck, V. Diadiuk, T. Jones and W. Lenth, Enhanced quantum efficiency internal photoemission detectors by grating coupling to the surface plasma waves, Appl. Phys. Letters, vol. 46, (10), 15 may 1985, pp. 915-917), a surface plasmon enhanced hot electrons photodetector based on Schottky contact between gold and p-type InP is demonstrated. The direct bandgap energy of InP is equal to Eg=1.344 eV, which means that absorption edge ($\lambda_{edge}$=h*c/Eg=1.24/Eg) of this semiconductor is equal to 1.24/1.344 =0.922 $\mu m$. Therefore, the incident IR light with wavelengths higher than 0.922 $\mu m$ cannot be absorbed by this semiconductor, as the energy of photons is smaller than the bandgap, and this energy is not enough for the transition of electrons from the valence band to the conduction band. Under these conditions the near-infrared (NIR) radiation is absorbed only by the metal, which is transferring this energy to the electrons located at and below the Fermi level. Most of these electrons will lose their energy by scattering with metal network, including electron-electron scattering. Only those energetic ("hot") electrons located near the metal-semiconductor interface, within a distance equal or lower than the mean-free path of electrons in metal, and which have an energy higher than the barrier height between the metal and semiconductor (hot electrons) may surmount the barrier ($\phi_B$) and enter the conduction band of the semiconductor. By simple calculations, one can prove that for the case of telecom wavelengths incident on a photodetector, a photocurrent will be generated by hot electrons emitted from the metal only if the barrier height is lower than 0.75 eV. Therefore, such Schottky energy barriers can have heights below 0.75 eV depending in the ideal case on the Fermi energy of the metal and semiconductor for telecom bands. The enhanced (plasmonic) electric field in the semiconductor at the interface between metal and semiconductor, in the depletion region of the Schottky contact will accelerate those hot electrons toward the opposite electrode (on the semiconductor) and generate the photocurrent. This process is called internal photoemission (IPE). From this IPE qualitative description one can understand that only a small fraction of the absorbed light in the metal can participate to the increase of the photodetector current above the value of the (dark) current of the detector. The above plasmonic Schottky (Au-InP) detector was obtained by using a periodically corrugated InP substrate, which was then covered with a thin metal gold. Thus, the surface plasmons generated at the surface of the corrugated Au metallization will create an enhanced resonant absorption at certain wavelengths, incidence and polarization angles and diffraction orders (m=1, 2,3) for which momentum matching occurs. In addition, an increased evanescent electric field in the semiconductor will be present, which will further accelerate the hot electrons and reduce their transit time between the two electrodes. All these effects together will increase the responsivity of the plasmonic detector with respect to a conventional one, but, overall, this IPE-based detector has a quantum efficiency of less than 2%, due to this low efficiency of hot electrons generation. For the increase of the IPE efficiency, some methods have been invented, as it will be shown in the next paragraphs. The above work is also experimentally proving the wavelength and incidence angle selectivity of the plasmonic detectors, as discussed in the previous paragraphs. The theory of MSM Schottky devices is described in detail in the work of Sze et al (S.M. Sze, D.J. Coleman Jr and A. Loya, Current transport in Metal-Semiconductor-Metal (MSM) structures, Solid State Electronics, vol.14, (1971), pp. 1209-1218. Briefly, the device consists of two back-to-back Schottky contacts on the same surface of substrate material, while the two metal-semiconductor junctions are made using the same type of metal. The major advantage of this structure is that it is obtained with a simple planar fabrication process, as the two electrodes are deposited and patterned simultaneously. As it will be shown in the next paragraphs, the interdigitated MSM Schottky consists of two interdigitated comb electrodes, where each comb electrode has a multitude of digits, which are interpenetrated by the digits of the second comb electrode. This MSM structure has been successfully applied for detection of long wavelength in optical communication, due to its low capacitance per area unit (Julian B.D. Soole and Hermann Schumacher, InGaAs Metal-Semiconductor-Metal Photodetectors for Long Wavelength optical communication, IEEE Journal of Quantum Electronics, vol. 27, No. 3, March 1991). Such a structure will be also used in the present invention, as the interdigitated electrodes can play a dual role, as both Schottky contacts of the MSM structure and metal optical grating for the surface plasmon polariton generation at the interface of metal with a semiconductor or a dielectric (air included).

As the present invention is also describing a radically new concept of reconfigurable plasmonic photodetector for visible range based on an interdigitated plasmonic MSM Schottky contact on chalcogenides phase change materials like $Sb_2S_3$, $Sb_2Se_3$ and its ternary nanocomposite $Sb_2S_xSe_{3-x}$ semiconductor, some basic aspects of these photonic devices are described here. The $Sb_2S_3$ chalcogenide semiconductor has a bandgap energy equal to about 2.2 eV in the amorphous state and 1.7 eV in the (poly)crystalline state. This means that the absorption edge is equal to $\lambda_{edge-am}$= 1.24/2.2=0.56 $\mu$m for the amorphous phase and $\lambda_{edge-crys}$=1.24/1.7=0.72 $\mu$m. Similarly, the $Sb_2Se_3$ chalcogenide semiconductor, with the bandgap of (1.24-1,5) eV will have the absorption edge at about 1 $\mu$m, in the polycrystalline state and about 0.8 $\mu$m in the amorphous state, (Delaney, M., Zeimpekis, I., Lawson, D., Hewak, D.W., Muskens, O.L., 2020. A New Family of Ultralow Loss Reversible Phase-Change Materials for Photonic Integrated Circuits: Sb2S3 and Sb2Se3. Adv. Funct. Mater. 30, 2002447) , respectively, covering even better the light absorption in the visible range. Therefore, for photons with energy higher than the above bandgaps, the absorption of the visible light is possible from the bulk of these semiconductor, by band-to-band electron transition, i.e., from valence band to conduction band. Thus, a pair electron-hole is generated, with the hole in the valence band, as a free charge carrier and electron as a free charge in the conduction band. Once these charge carriers are generated inside the depletion region of the MSM Schottky, they are separated by the electric field existing in the depletion region of the metal-semiconductor contact and then electrons go the positive biased electrode and holes to the negative biased electrode determining thus the photocurrent. Unlike the conventional detectors for visible light based on $Sb_2S_3$ (M. Zhong, X. Wang, S. Liu, B. Li, L. Huang, Y. Cui, J. Li, and Z. Wei, High performance photodetector based on Sb2S3 nanowire: wavelength dependence and wide temperature range utilization, Nanoscale, Nanoscale, 2017, vol.9, pp. 12364-12371) or $Sb_2Se_3$ absorber, as described above, the plasmonic MSM interdigitated Schottky photodetector from the present invention benefits of the surface plasmon light waves and enhanced evanescent electrical fields in the depletion region, which may increase the photocurrent by about one order magnitude.

As revealed in this and the next paragraphs, considering the specific features of the surface plasmon polaritons generated at the interface between a metal and a dielectric/semiconductor or even air, with main focus on enhanced evanescent electric fields at that interface, a continuously increasing number of photoconductive plasmonic devices for different photonic applications are emerging. Thus, in the US 5 625 729 patent dated 29 April, 1997, it is disclosed an optoelectronic device consisting of two interdigitated metal comb electrodes, which are used as both electrodes between which an electrical voltage can be applied, and as a periodic optical grating for coupling the external optical wave to a local wave on the substrate. The local wave could be either a surface plasmon evanescent wave, due to the surface plasmon generation on the periodic grating, or a total internal reflection guided wave. The author is claiming multiple applications for this device, like optical modulators or photodetectors. In the case of the modulator, when an external optical wave is incident on the biased interdigitated structure, a reflected wave is modulated by the changes of the refractive index of the substrate due to the applied voltage between the two interdigitated electrodes. In the case of the photodetector, this electrooptical device is used for the sensing of the electric (photo)current between the two biased interdigitated electrodes, in the presence of the external optical wave incident on the structure. The author mentions both types of metal-semiconductor contacts, either ohmic or Schottky, but he does not claim the hot electron Schottky detector. In addition, he does not claim the family of semiconducting chalcogenides for its use as a substrate for photodetectors, and, finally, the concept of reconfigurable plasmonic photodetector performed on phase change semiconductor material was not disclosed by anybody in the prior art, from the best of our knowledge.

The US 7 026 701 B2 patent, dated 11 April 2006, is disclosing a Schottky barrier photodetector with a metal strip embedded near the surface of silicon semiconductor. This strip is acting in the same time as a contact to silicon and a plasmonic wave guide at the interface between the metal and silicon. Due to a specific geometry of the metal strip with its width equal to the thickness, the authors are claiming a polarization-independent plasmonic photodetector and a possible increase of the quantum efficiency, which is an advantage considering the multiple selectivity of the plasmonic devices. This patent is also claiming an increased efficiency of the photodetector, due to an increased number of interfaces between a metal and a semiconductor, which can increase the total active area of the device. The concept is developed in the silicon bipolar technology, while the authors claim its applicability to other semiconductor materials from IV, III-V, II-VI column of the Mendeleev periodic table. A detailed evaluation of the types of the semiconductor materials claimed in the patent reveals the fact that it does not include the family of the V-VI chalcogenide semiconductors, like $Sb_2S_3$, $Sb_2Se_3$, $Sb_2S_xSe_{3-x}$ semiconductor, as a potential active material for light absorption. In addition, there is no mention about a possible plasmonic photodetector based on phase change materials (PCM).

The US 2011/0175183 A1 patent, published on 21 July 2011, is disclosing a metal-semiconductor-metal (MSM) plasmonic photodetector aiming the increase of the quantum efficiency. Each metal electrode of the device contains a plasmonic lens performed by doing a periodic corrugation in the metal layer. Such a corrugation can be obtained by etching superficial parallel trenches with a certain periodicity in the metal film, or by superficially etching the metal so that to obtain circular trenches around a central point. The plasmonic lentils have the role to concentrate the light on the lens, increase the evanescent electric field in the semiconductor and thus to increase the number of free carriers in the semiconductor, the speed of the carriers and determine an increase of the photocurrent, without reducing the bandwidth due to length of the lens. The patented device does not contain interpenetrating metal fingers, as the two plasmonic lenses are separated one from the other, and it does not consider phase change chalcogenide materials or reconfigurability, to mention only a few differences with respect to the present invention.

The US 11 112 305 B2 patent, dated 7 September 2021, discloses a photoconductive plasmonic device working as either THz detector or emitter. The system consists of an active semiconductor layer which is able to absorb light at the specified wavelength of the optical pump input signal incident on the detector area, two plasmonic comb electrodes which are *not* interdigitated one to the other, and an antenna. Each of the plasmonic comb electrodes contains a metal grating made of parallel and periodic digits. Specific to this invention is the fact that there is a small distance between the two comb plasmonic electrodes, where the light is freely absorbed, but where the surface plasmons may still enhance the light concentrations and the evanescent electric field, which will further increase the transit time of the photogenerated carriers. Like in the previously described patents, in this patent the digits of the comb electrodes with their periodic arrangement on the surface of semiconductor will make possible the generation of surface plasmon waves and the associated advantages. This patent extends the family of the existing plasmonic photonic devices, and allow fabrication of high-power THz emitter/detectors, but does not overlap with the specific claims of our invention related to IR and visible plasmonic *interdigitated* photodetectors on chalcogenide semiconductor, as it will be very clear from the claims of our invention, where for the first-time reconfigurable photodetectors are disclosed.

The US 2020/0144437 A1 patent is disclosing an IR photodetector based on the contact between a metal and a semiconductor, where the semiconductor is surrounding the metal strip on at least three sides. The purpose of the patent is to improve the efficiency of the radiation coupling between an optical fiber and photodetector, up to a level of (90-98) %. This result is targeted by means of an extended surface area of the metal-semiconductor (MS) interface, due to those multiple MS contacts. Unlike the invention disclosed in US 7 026 701 B2 patent, where the plasmonic metal strip was embedded in the bulk of the semiconductor, this Schottky photodetector is located at the surface of the semiconductor and describes explicitly that the principle of operation in the telecom band (1.1-1.6 $\mu$m) is based on internal photoemission (IPE) of hot electrons from the metal, the semiconductor being transparent at this wavelength band. As can be observed from the claims and the entire content of the US 2020/0144437 A1 patent, only well-known semiconductor material like Si is used, which is transparent to NIR telecom wavelengths. Therefore, it is easy to notice the conceptual differences at the level of design and materials used within our patent with respect to this patent, not to mention the reconfigurable feature of our IR photodetector based on phase change materials, which has never been disclosed before, after our best knowledge.

The US 7 106 374 B1 patent describes a dynamically reconfigurable close-loop vision system containing complex computing units for imaging data processing, as well as a reconfigurable photodetector array containing a multitude of optical devices able to detect light in a wide wavelength spectrum from ultraviolet to near infrared. The term "reconfigurable" here means the ability of the system to collect the relevant pixel data from the fix structure of the photodetector array, by varying the temporal and spatial parameters of the human or computer-controlled optical data collection system. Therefore, the innovative step would be to go from computer-controlled reconfigurable optical system to device-level reconfigurability, and this will be disclosed in the following paragraphs of our invention.

## SUMMARY

The present invention is disclosing reconfigurable photodetectors, a radically-new concept of surface plasmon enhanced metal-semiconductor-metal (MSM) interdigitated Schottky photonic photodetectors, where the semiconductor is from the family of chalcogenide phase change materials like $Sb_2S_3$, $Sb_2Se_3$, and their ternary composites $Sb_2S_xSe_{3-x}$, which presents similar wavelength-dependent optical contrast for the complex refractive index, when they switch repeatedly from the amorphous state to (poly)crystalline state. In certain embodiments, the reconfigurable plasmonic interdigitated MSM Schottky hot electron-based photodetector is used for the detection of the IR telecom band (1.26-1.675) $\mu$m. The novelty of the invention comes from the device-level reconfigurability of the present plasmonic photodetector, which, for example, is able to detect the telecom "C band" (1.530-1.565) $\mu$m when the device has the $Sb_2S_3$ (or $Sb_2Se_3$, or $Sb_2S_xSe_{3-x}$) film in the (poly)crystalline state, and the "O band" (1.26-1.36) $\mu$m when the same device (obviously, no change of the grating period) has the $Sb_2S_3$ (or $Sb_2Se_3$ or $Sb_2S_xSe_{3-x}$) switched in the amorphous state. Similarly, a reconfigurable plasmonic interdigitated MSM hot electron Schottky photodetector is able to detect the telecom "U band" (1.625-1.675) $\mu$m when the device has the $Sb_2S_3$ (or $Sb_2Se_3$) film in the (poly)crystalline state and the "E band" (1.36 - 1.46) $\mu$m, when the same device has switched the $Sb_2S_3$ (or $Sb_2Se_3$ or $Sb_2S_xSe_{3-x}$) film in the amorphous state. The repeatable (poly)crystalline-amorphous-(poly)crystalline phase transition can be optically performed as described in the background. The wavelength selectivity of the plasmonic devices is further supporting the filter-type functionality of the IR detector. Thus, it is for the first time when the same device can be optically tuned to perform hopping between two telecom wavelength bands, and this change to be operational in a nanosecond time scale. In addition, our invention will show that by an original design of the plasmonic photodetector, containing multiple photodetectors connected in parallel, a wideband, multi-polarization IR photodetector can be also obtained.

In another embodiment, a reconfigurable plasmonic interdigitated MSM Schottky photodetectors for the visible spectrum is disclosed. In this case, the visible incident light with the energy of photons higher than the bandgap energy of $Sb_2S_3$ and $Sb_2Se_3$ and their ternary nanocomposites $Sb_2S_xSe_{3-x}$ will be absorbed by the bulk of chalcogenide semiconductor and generate a photocurrent. The figure of merit (FOM) in the visible range is much much smaller than in the IR wavelength band, due to absorption of the photons with their energy higher than the bandgap of these chalcogenides. The optical contrast in the refractive index between the crystalline state and amorphous state of $Sb_2S_3$ is enough for obtaining a reconfigurable plasmonic photodetector, which, for example will detect the orange color in the crystalline state and the green color in the amorphous state for the case of $Sb_2S_3$ as an active absorber. Similarly, as an example, the reconfigurable plasmonic photodetector based on $Sb_2Se_3$ as absorber is able to detect orange color (600 nm) in the polycystalline state and blue color (500 nm) in the amorphous state. Considering the inherent wavelength selectivity of the plasmonic photodetector, the reconfigurable plasmonic photodetectors will represent a major functionality increase of these photonic devices.

In another embodiment, a method for the fabrication of these IR reconfigurable plasmonic interdigitated MSM Schottky hot electron photodetector is presented. Thus, in the first step the chalcogenide film ($Sb_2S_3$ or $Sb_2Se_3$ or $Sb_2S_xSe_{3-x}$), is deposited on a dielectric substrate and then the plasmonic metal electrodes are deposited and patterned above the chalcogenide semiconductor, where the metal deposition may be preceded by an ultrathin barrier layer, e.g., like $Si_3N_4$ (2-3 nm thick) located in-between the metal like aluminum and chalcogenides. In the case of gold metallization, a titanium barrier layer of 2-3 nm can be deposited before gold deposition and patterning. Finally, above the entire structure an anti-reflection, capping layer of ZnS (20%)-$SiO_2$(80%) composite with a thickness of 50-100 nm is deposited over the plasmonic device for avoiding the sulfur or selenium loss during crystallization and amorphization anneals and thus preserving the stoichiometry of the chalcogenide film during optical/thermal treatments. On-chip reconfigurability is performed by thermal or laser annealing of the chalcogenide so that a phase transition from amorphous phase to polycrystalline phase takes place. For the phase transition of each of the chalcogenides from above from the polycrystalline phase to amorphous phase an ultrarapid laser annealing of the device to bring the OPCM material to a specific temperature, above melting point of that material followed by the very rapid cooling of the device is done.

In another embodiment, a method for the fabrication of IR reconfigurable plasmonic interdigitated MSM Schottky photodetector is started by depositing the metal directly on the isolating substrate (Si/$SiO_2$, $Al_2O_3$, glass), eventually preceded by the deposition of a barrier or adherence layer, followed by metal layer patterning for creating the interdigitated metal electrodes and grating. Then, the conformal deposition of the chalcogenide semiconductor is made, and finally the protection, anti-reflection coating of ZnS(20%)-SiO$_2$(80%) is deposited. The highest quantum efficiency of the IR reconfigurable plasmonic interdigitated MSM Schottky hot electron photodetectors can be obtained when the plasmonic metal electrodes are fully embedded in the chalcogenide Sb$_2$S$_3$ semiconductor, due to the fact that Schottky contacts are formed at all four interfaces between the metal and semiconductor.

In another embodiment, different methods for the design and fabrication of the reconfigurable plasmonic interdigitated metal-semiconductor-metal Schottky detectors for visible light are disclosed. Due to the light absorption in the entire depletion region of the chalcogenide film, the quantum efficiency of these reconfigurable photodetectors for visible range is much higher than that of the IR reconfigurable photodetectors, which are based on internal photoelectron emission (IPE).

**BRIEF DESCRIPTION OF DRAWINGS**

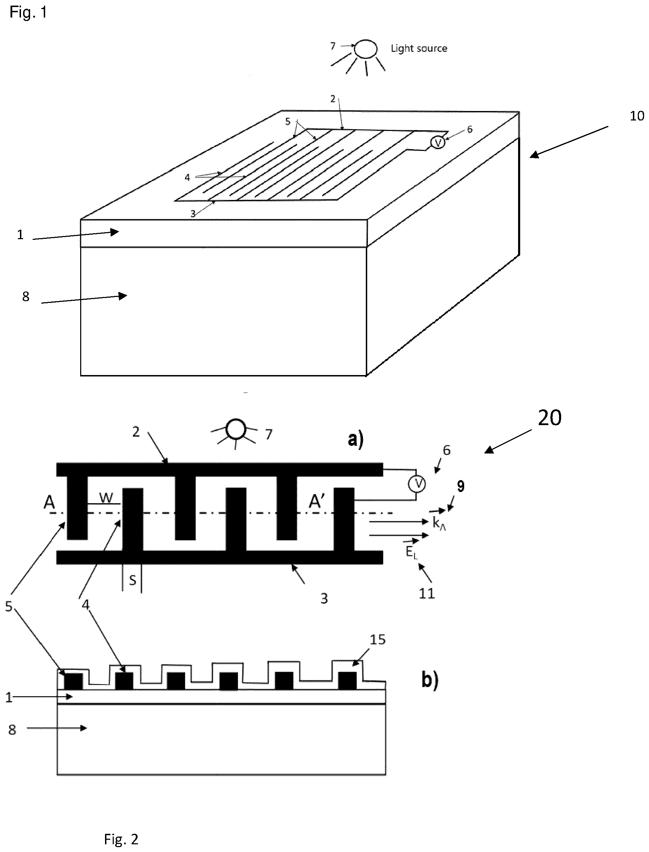

The embodiments of the present disclosure will be described only as an example, by reference to Figs. 1- 18 of the accompanying drawings in which:

Fig. 1 shows a perspective view of an interdigitated plasmonic photodetector based on metal-semiconductor-metal (MSM) Schottky barrier, in accordance with at least one example of the present invention.

Fig. 2 shows in the upper side (a) A top-view of a MSM Schottky plasmonic photodetector based on an interdigitated grating with dual role: electric and optic, and, in the lower side (b) A cross-section view through the axis A-A' of the photodetector from Fig. 2(a).

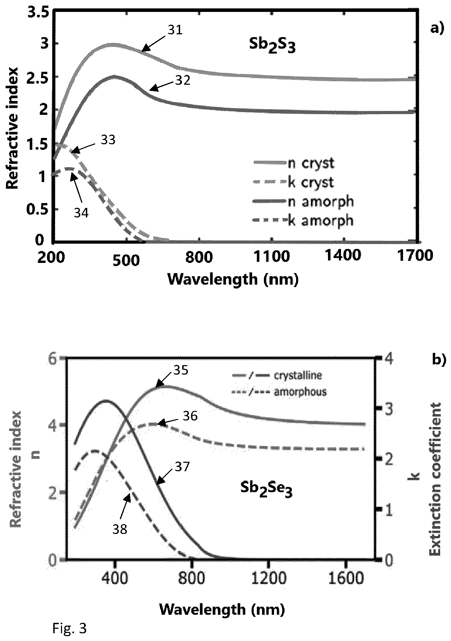

Fig. 3 shows the experimental values of the refractive index, n, and extinction coefficient, k, of Sb$_2$S$_3$ (a) (Gutierrez, Y., Fernández, A., Rosales, S., Cobianu, C., Gheorghe, M., Modreanu, M., Saiz, J., Moreno, F., Losurdo, M., 2022. Polarimetry Analysis and Optical Contrast of Sb2S3 Phase Change Material. Opt. Materials Express, Vol. 12, No. 4 / 1 Apr 2022, pp. 1531-1541) https://doi.org/10.1364/QME.450781, and Sb$_2$Se$_3$ (b) (Delaney, M., Zeimpekis, I., Lawson, D., Hewak, D.W., Muskens, O.L., 2020. A New Family of Ultralow Loss Reversible Phase-Change Materials for Photonic Integrated Circuits: Sb2 S3 and Sb2Se3. Adv. Funct. Mater. 30, 2002447. https://doi.org/10.1002/adfm.202002447,) as a function of wavelength and structural state of the film (amorphous or crystalline).

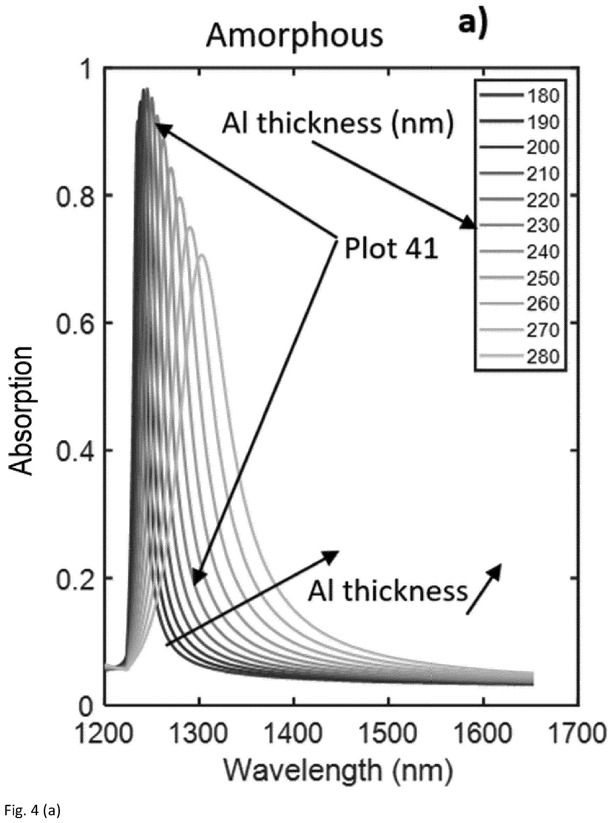

Fig. 4 (a) shows the numerical simulation results of the resonance absorption vs IR incident light for the plasmonic photodetector with aluminum grating (digit width W= 593 nm, interdigit spacing S=30 nm, and P=W+S=623 nm) and an amorphous Sb$_2$S$_3$ layer, for different thicknesses of the aluminum grating. Simulations performed for diffraction order, m=1, normal incident radiation. For an Al thickness equal to 230 nm, the resonant absorption takes place at the telecom O-band (1260-1360 nm).

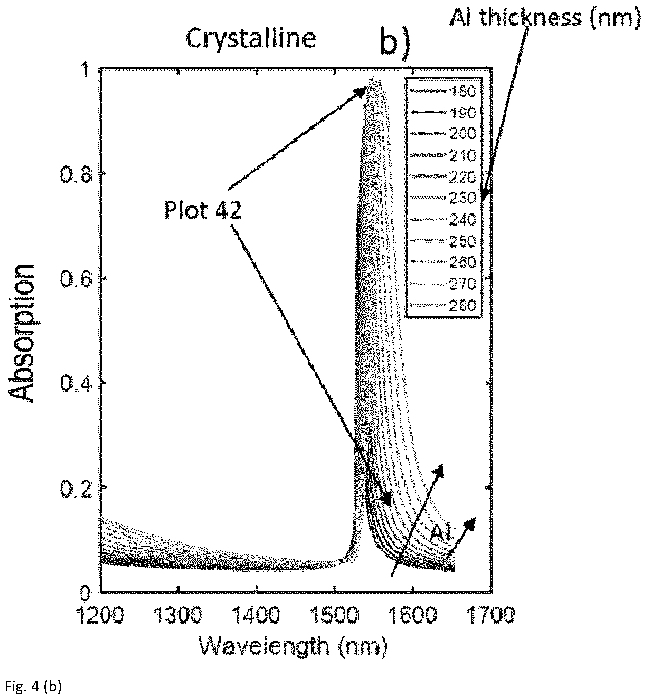

Fig. 4 (b) shows the numerical simulation results of the resonance absorption vs IR incident light for the plasmonic photodetector with aluminum grating (digit width W= 593 nm, interdigit spacing S=30 nm, and P=W+S=623 nm) and a crystalline Sb$_2$S$_3$ layer, for different thicknesses of the aluminum grating. Simulations performed for diffraction order, m=1, normal incident radiation. For an Al thickness equal to 230 nm, the resonant absorption takes place at the 1550 nm telecom C band (1530-1565 nm).

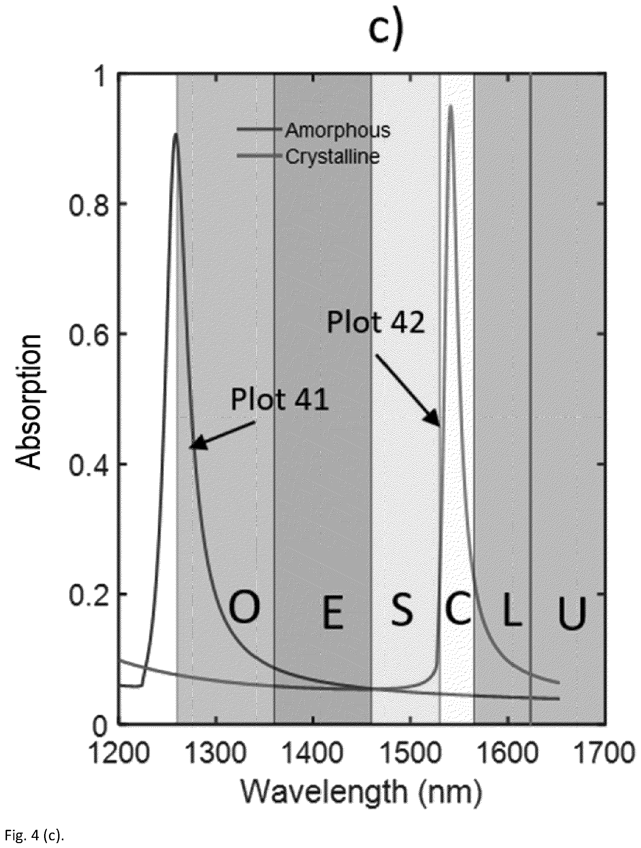

Fig. 4 (c) shows the combination of the simulation results from Figs. 4(a) and 4(b) for evidencing a reconfigurable IR plasmonic interdigitated photodetector which is hopping from the detection of 1550 nm telecom **C** wavelength band (Plot 42), when the detector is in the crystalline state to the detection of 1260 nm telecom **O** band, (Plot 41) when the detector is in the amorphous state. Simulation result obtained by using an aluminum grating (acting also as electrodes) with digit width W=593 nm, spacing between digits, S=30 nm, period of grating=623 nm, Al thickness=230 nm, for normal incidence of the IR radiation and diffraction order, m=1.

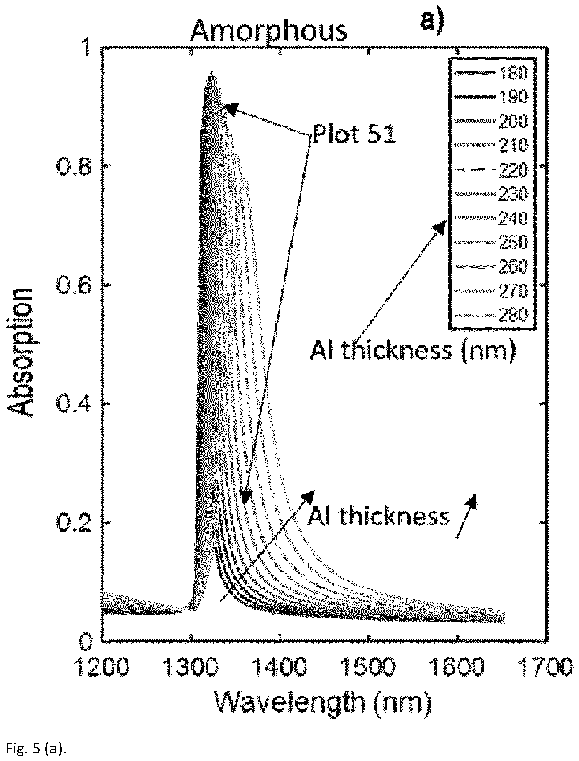

Fig. 5 (a) shows the numerical simulation results of the resonance absorption vs IR incident light for the plasmonic photodetector with aluminum grating (digit width W= 636 nm, interdigit spacing S=30 nm, and P=W+S=666 nm) and an amorphous Sb$_2$S$_3$ layer, for different thicknesses of the aluminum grating. Simulations performed for diffraction order, m=1, normal incident radiation. For an Al thickness equal to 240 nm (Plot 51), the resonant absorption takes place at the telecom E band (1360-1460 nm).

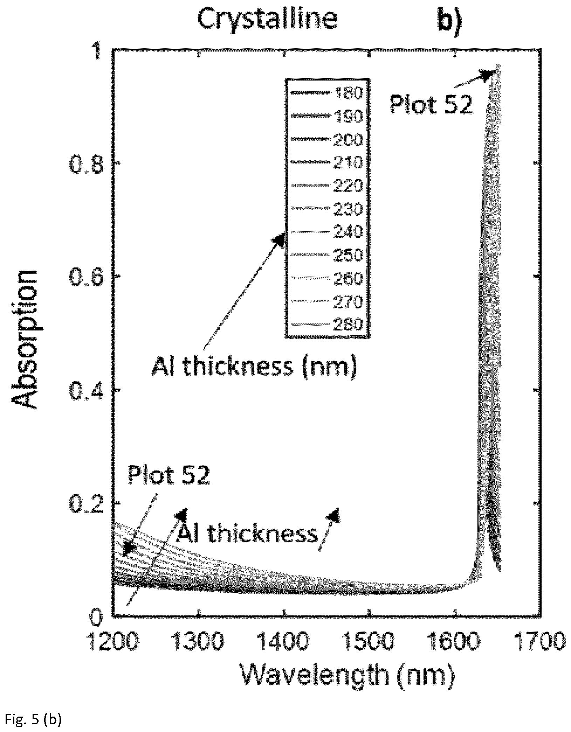

Fig. 5 (b) shows the numerical simulation results of the resonance absorption vs IR incident light for the plasmonic photodetector with aluminum grating (digit width W=636 nm, interdigit spacing S=30 nm, and P=W+S=666 nm) and a crystalline Sb$_2$S$_3$ layer, for different thicknesses of the aluminum grating. Simulations performed for diffraction order, m=1, normal incident radiation. For an Al thickness equal to 240 nm (Plot 52), the resonant absorption takes place at the 1650 nm telecom U band (1625-1675 nm).

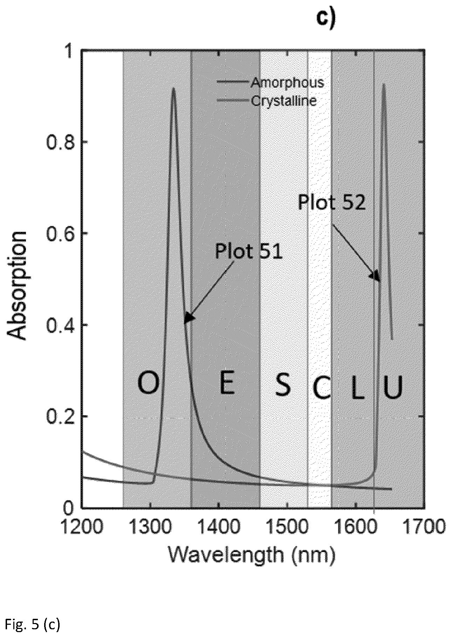

Fig. 5 (c) shows the combination of the results from Figs. 5(a) and 5(b) for evidencing an IR reconfigurable plasmonic interdigitated photodetector which is hopping from the detection of 1650 nm telecom **U** wavelength band, (Plot 52) when the detector is in the crystalline state to the detection of 1360 nm telecom **O** band (1260-1360) nm (Plot 51), when the detector is in the amorphous state. Simulation result obtained by using an aluminum grating (acting also as electrodes) with digit width W=636 nm, spacing between digits, S=30 nm, period of grating=666 nm, Al thickness=230 nm, for normal incidence of the IR radiation and diffraction order, m=1.

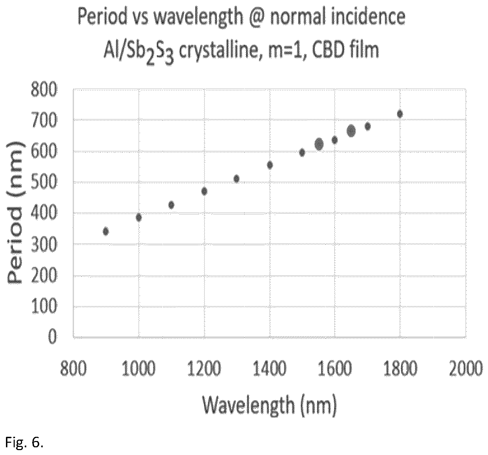

Fig. 6 shows the results of analytical (small dots) and numerical (big dots) simulation of the period of aluminum grating period as a function of resonant incident IR wavelengths, for the case of a plasmonic photodetector with aluminum grating (acting also as electrodes) and crystalline $Sb_2S_3$ layer. For both simulation approaches, the optical constant of chemically bath deposited (CBD) $Sb_2S_3$ films from Fig. 3 (a) were used, and also, normal incidence and first order of diffraction was considered.

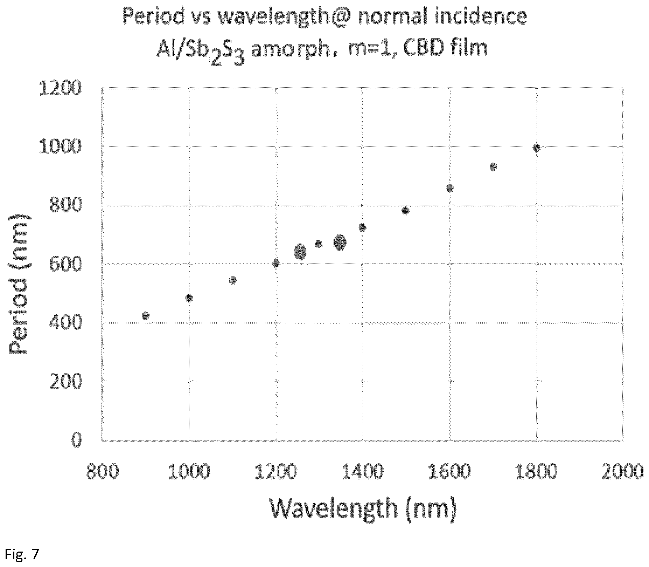

Fig. 7 shows the results of analytical (small dots) and numerical (big dots) simulation of the period of aluminum grating period as a function of resonant incident IR wavelengths, for the case of a plasmonic photodetector with aluminum grating (acting also as electrodes) and amorphous $Sb_2S_3$ layer. For both simulation approaches, the optical constant of chemically bath deposited (CBD) $Sb_2S_3$ films from Fig. 3 (a) were used, and also, normal incidence and first order of diffraction was considered.

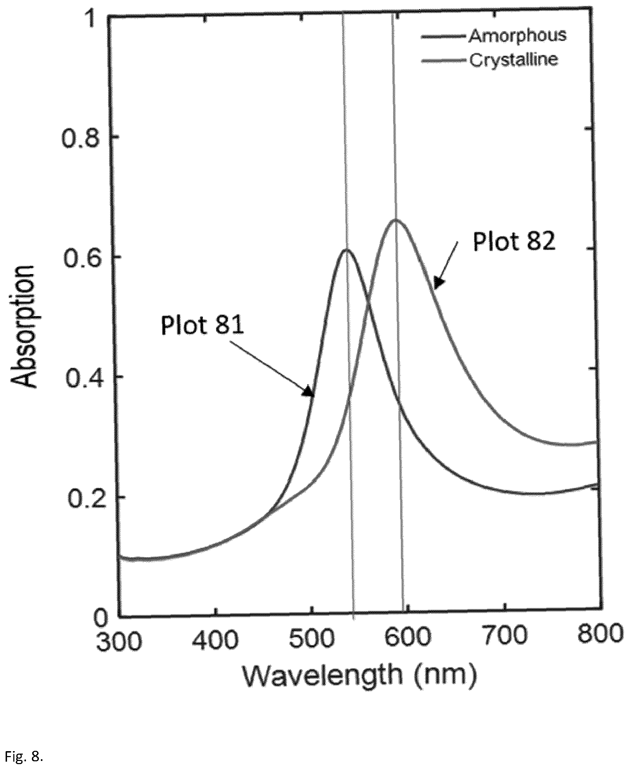

Fig. 8 shows the numerical simulation results of the resonance absorption vs visible incident light evidencing the hopping from the detection of orange light (Plot 82) to the detection of green light (Plot 81) when the interdigitated plasmonic photodetector with aluminum grating of thickness equal to 120 nm, digit width W=139 nm, interdigit spacing S=30 nm, and P=W+S=169 nm) is switching from the crystalline state of $Sb_2S_3$ layer to its amorphous state. Simulations were performed for diffraction order, m=1, normal incident radiation.

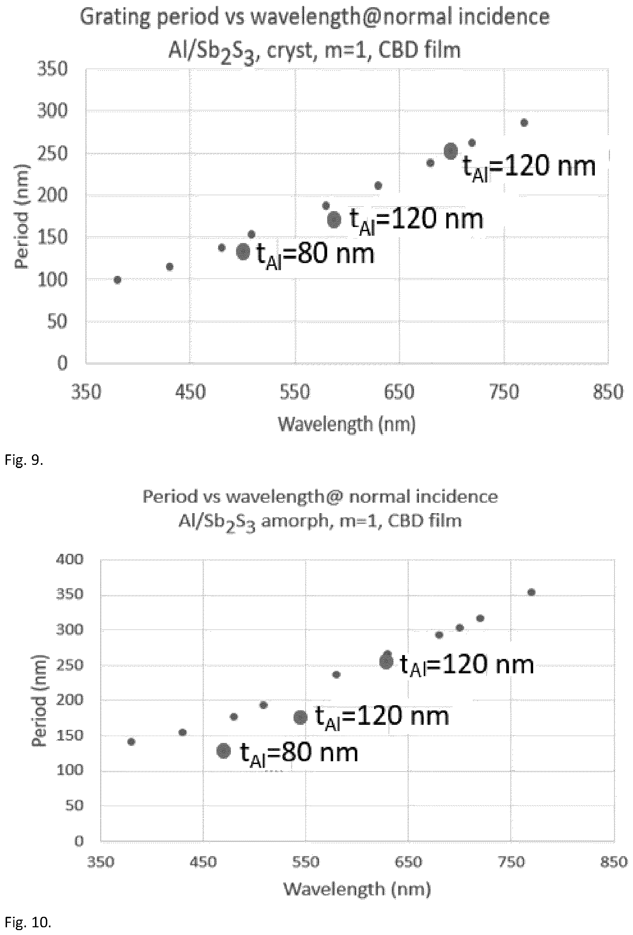

Fig. 9 shows the results of the analytical (small dots) and numerical (big dots) simulation of the period of the aluminum grating as a function of resonant incident visible wavelengths, for the case of an interdigitated plasmonic photodetector with aluminum grating (acting also as electrodes) and crystalline $Sb_2S_3$ layer. For both simulation approaches, the optical constants of chemically bath deposited $Sb_2S_3$ (CBD) film from Fig. 3 (a) were used, and also, normal incidence and first order of diffraction, m=1, was considered.

Fig. 10 shows the results of the analytical (small dots) and numerical (big dots) simulation of the period of the aluminum grating as a function of resonant incident visible wavelengths, for the case of a plasmonic photodetector with aluminum grating (acting also as electrodes) and amorphous $Sb_2S_3$ layer. For both simulation approaches, the optical constants of chemically bath deposited (CBD) $Sb_2S_3$ film from Fig. 3 (a) were used, and also, normal incidence and first order of diffraction was considered.

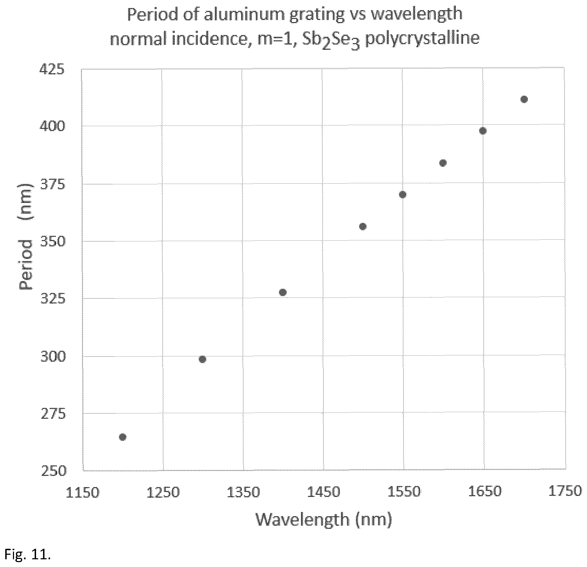

Fig. 11 shows the results of the analytical simulation of the period of the aluminum grating as a function of resonant incident IR wavelengths, for the case of an interdigitated plasmonic photodetector with aluminum grating (acting also as electrodes) and crystalline $Sb_2Se_3$ layer. The optical constants of $Sb_2Se_3$ RF magnetron sputtering deposited films from Fig. 3 (b) were used, and also, normal incidence and first order of diffraction, m=1, was considered.

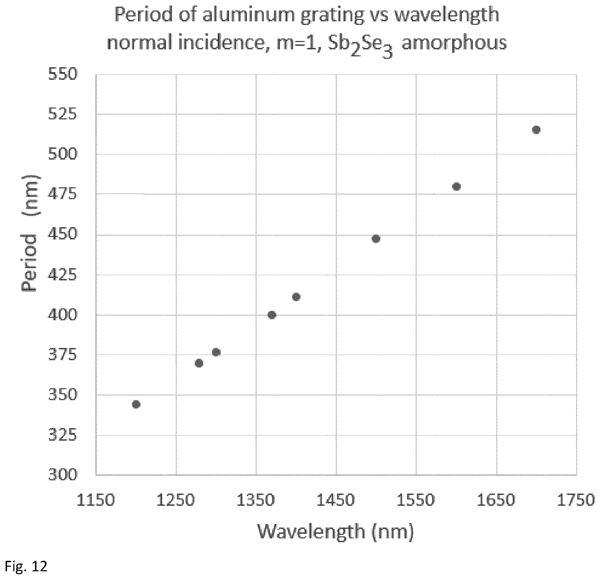

Fig. 12 shows the results of the analytical simulation of the period of aluminum grating period as a function of resonant incident IR wavelengths, for the case of an interdigitated plasmonic photodetector with aluminum grating (acting also as electrodes) and amorphous $Sb_2Se_3$ layer. The optical constants of $Sb_2Se_3$ RF magnetron sputtering deposited films from

Fig. 3 (b) were used, and also, normal incidence and first order of diffraction was considered.

Fig. 13 shows the results of the analytical simulation of the period of aluminum grating period as a function of resonant incident visible wavelengths, for the case of a plasmonic photodetector with aluminum grating (acting also as electrodes) and polycrystalline $Sb_2Se_3$ layer. The optical constant of $Sb_2Se_3$ RF magnetron sputtering deposited films from Fig. 3 (b) were used, and also, normal incidence and first order of diffraction was considered.

Fig. 14 shows the results of the analytical simulation of the period of aluminum grating period as a function of resonant incident visible wavelengths, for the case of a plasmonic photodetector with aluminum grating (acting also as electrodes) and amorphous $Sb_2Se_3$ layer. The optical constants of $Sb_2Se_3$ RF magnetron sputtering deposited films from Fig. 3 (b) were used, and also, normal incidence and first order of diffraction was considered.

Fig. 15 shows the top view of the metal grating (and electrodes) of a reconfigurable, wideband plasmonic photodetector containing "n" plasmonic photodetectors, connected electrically in parallel.

Fig. 16 shows the top view of the metal grating (and electrodes) of a reconfigurable multipolar plasmonic interdigitated photodetector.

Fig. 17 shows the cross-sectional view of the reconfigurable MSM Schottky hot electron plasmonic photodetector with three metal-semiconductor interfaces for IR telecom band spectrum detection, with metal deposition directly on the dielectric substrate, and chalcogenide semiconductor deposited above the metal. An anti-reflection capping layer of $ZnS(20\%)$-$SiO_2(80\%)$ is covering the entire structure.

Fig. 18. Cross section view of the reconfigurable MSM Schottky hot electron plasmonic photodetector with four metal-semiconductor interfaces for IR telecom band spectrum detection, with metal deposition embedded in the chalcogenide semiconductor, and capping layer of $ZnS$ (20%)-$SiO2(80)\%$.

## DETAILED DESCRIPTION

The following description should be read and understood with reference to the above drawings. These drawings are not necessarily at scale and are not intended to limit the scope of the invention. Although different examples of the design of the novel reconfigurable plasmonic photodetectors are illustrated in those figures, the people skilled in the art will recognize that the provided examples have many suitable alternatives that may be utilized.

Fig. 1 shows a schematic perspective-view of an interdigitated metal-semiconductor metal (MSM) plasmonic Schottky photodetector (10), which is defined as two-electrode optoelectronic device with both electrodes placed on the same surface of semiconductor substrate (8), where the planar metallization of the device, 10, in direct contact with the semiconductor 1 has dual role, i.e., both electric role as metal electrode for extracting the photocurrent from the device, and optic role, as grating, for the generation of the surface plasmon at the interface between metal and air or metal-substrate when the momentum matching condition described in the background of this invention. The first collecting metal electrode, 2, is provided with a number of digits, 5 positioned perpendicularly on the first collecting electrode, 2, and the second collecting electrode, 3, is provided with a number of digits, 4, positioned perpendicularly on the second collecting electrode. These fingers, 4 and 5, are interpenetrated, without touching one another, as shown in Fig. 1. These collecting electrodes, 2 and 3 are connected to a dc power supply, 6. In the same circuit a microampere meter can be added for photocurrent measurement. Together, the first collecting electrode, 2, and the second collecting electrode, 3, together with their digits, 5, and 4 respectively, define also an interdigitated grating with a certain periodicity of the digits and spacing between them. The external radiation source, 7, is placed above the grating, and the incident radiation is characterized by wavelength, incidence angle with respect to the direction normal on the photodetector surface and polarization angle of the electric field $\mathbf{E_L}$, 11, with respect to the grating vector, $\mathbf{k}_\Lambda$, 9, as defined in the background, and shown in Fig. 2 (a). The substrate, 8, of the photodetector, 10, electrically isolated from the semiconducting layer, 1, can be a silicon wafer covered with a $SiO_2$ layer of thickness in the range 0.5-1 $\mu$m, or sapphire, or glass wafer, but not restricted to these examples.

Fig. 2 illustrates in the upper section (a) a detailed top-view of the interdigitated MSM Schottky photodetector and in the lower section (b) a cross-section view of the same photodetector. Thus, in Fig. 2 (a), where the reference numbers have the same significance as in Fig. 1, it is easy to notice that the period of the metal interdigitated grating is equal with the sum between the width, W, of the fingers 4 or 5 and the space, S, between two adjacent fingers, 4 and 5. The grating with the period, $P= \Lambda =W+S$, is optically characterized as a vector, by the grating vector, 9, denoted by $\mathbf{k}_\Lambda$, with the magnitude, $k_\Lambda =2\pi/\Lambda$, and the direction perpendicular to the length of the digits, as shown in Fig. 2 (a). In Fig. 2 (a) the electric field vector, $\mathbf{E_L}$, 11, is parallel to the grating vector, $\mathbf{k}_\Lambda$, 9, and perpendicular to the length of the digits, the light being **p-polarized.** For this vectorial configuration, the polarization angle, $\delta$, between the incident light and the grating is equal to zero, and therefore according to the equation [5] the generated plasmonic photocurrent is maximum, only for this case of $\mathbf{E_L} \parallel \mathbf{k}_\Lambda$. In Fig. 2(b), one can notice that the metal fingers, 4, and 5 make a direct contact on the surface of the chalcogenide semiconductor, 1, which could be $Sb_2S_3$, $Sb_2Se_3$, or their ternary composite, as a solid solution, $Sb_2S_xSe_{3-x}$. In addition, above the entire surface of the device, the capping layer, 15, of $ZnS(20\%)$-$SiO_2(80\%)$ with a thickness of 50-100 nm is deposited. This layer is preserving the stoichiometry of the chalcogenide semiconductor during optical or thermal annealing for crystallization and amorphization, and it is also an anti-reflection coating, with a refractive index higher than that of the air and smaller than that of the chalcogenide.

For the realization of a plasmonic interdigitated metal-semiconductor-metal photodetector from Figs. 1 and 2, the collecting electrodes, 2 and 3 and their digits 4 and 5, should have the real part of the dielectric constant with a negative value in the optical spectrum of interest, which should be lower than the negative value of the dielectric constant, n, of the material from the interface. Such plasmonic metals are gold, silver, aluminum, or even gallium. A key aspect of this invention is that the entire design of the photodetector is performed for surface plasmon polaritons generation at the interface between metal (2, 3, 4, 5) and the chalcogenide semiconductor,!, so that the enhanced evanescent electric field in semiconductor due to extraordinary light transmission through the interdigit spacings, S, to be maximum in the semiconductor, 1, near the interface between metal and semiconductor, in its depletion region.

The height of the Schottky barrier between metal and semiconductor depends on the work function of metal, the electron affinity in the semiconductor, the type of semiconductor (n-type or p-type), and the density of the surface states at the interface between metal and semiconductor, in the energy bandgap of the semiconductor,!. If this density of states is very high, the barrier height will be very weakly dependent or even not dependent on the metal work function.

Figs. 3 (a) and (b) show the dependence of the refractive index, n, and the extinction coefficient, k, as a function of incident wavelength in the domain 200-1700 nm, covering the ultraviolet, visible and near infrared (NIR) spectrum for the case of chemically bath deposited (CBD) $Sb_2S_3$ films (Fig. 3(a)) and physically vapor deposited (PVD) $Sb_2Se_3$ films (Fig. 3(b)). In Fig. 3(a), the plots 31 and 33 show the variation of the refractive index, n, and extinction coefficient, k, of polycrystalline CBD $Sb_2S_3$ film as a function wavelength, respectively, while the plots 32 and 34 show the refractive index and extinction coefficient for the amorphous CBD $Sb_2S_3$ film, respectively. The crystallization temperature of the CBD $Sb_2S_3$ was about 270°C, the onset of the crystallization process starting at about 220°C. The CBD deposition mechanism, as an electroless process, consists of dissolving and dissociation of the $SbCl_3$ and $Na_2S_2O_3$ precursors followed by the adsorption and reaction of cations ($Sb^+$) and anions ($S^-$) of these reagents for nucleating and growing the film of $Sb_2S_3$. Such a chemical deposition mechanism is determining a rather porous film, which may explain why the refractive indexes for CBD $Sb_2S_3$ are systematically lower than the same values of the $Sb_2S_3$ films obtained by (PVD) sputtering process where energetic Sb and S atoms are rather "implanted" in the film, making denser films, as described in the cited literature from background of this invention. In Fig. 3(a), the Plots 33 and 34 of extinction coefficient, k, confirm absorption edge at about 600 nm (bandgap of about 2 eV) for the amorphous $Sb_2S_3$ film and an absorption edge of about 700 nm (1.7 eV) for the (poly)crystalline film, respectively. From these two plots it is obvious that both amorphous and polycrystalline CBD $Sb_2S_3$ films are not absorbing radiation in the NIR spectrum, and this explains the use of such material in specific applications where transparency of the film is needed. In the same time the classical FOM is practically equal to infinity for the telecom wavelengths (1.26-1.675 $\mu$m). In Fig. 3 (b), the Plots 35-38 show the variation of the refractive index, n, and extinction coefficient, k, for the sputtering-deposited $Sb_2Se_3$ films. Rather similar type of dependencies of n and k with wavelength can be easily noticed for these with films with respect to $Sb_2S_3$ films. The differences consist in higher values of the refractive index in $Sb_2Se_3$ due to the sputtering process, as explained above, and the red shift of the absorption edges of the (poly)crystalline and amorphous $Sb_2Se_3$ films, due to the lower bandgap of these films. Actually, from absorption edges of the Plots 37 and 38 of extinction coefficient, one can easily calculate the bandgap of $Sb_2Se_3$ amorphous film (1.55 eV) and (poly)crystalline film (1.24 eV). Again, an excellent transparency of the $Sb_2Se_3$ film to the telecom wavelengths is obtained. As demonstrated in the background of this invention, the above values of the refractive index are used for the calculation of the grating period which will match the momentum law for surface plasmon generation. The values of the refractive index of the plasmonic metals (which have negative sign in the optical spectrum) are taken from excellent database, as described above.

Fig. 4(a) shows the results of the numerical simulations of the absorption of the telecom wavelengths (1.26-1.675) $\mu$m in the plasmonic interdigitated metal-semiconductor-metal (MSM) Schottky hot electron photodetector, 20, described in Fig. 2, where the metal (2, 3, 4, 5) is aluminum and the semiconductor (1) is amorphous $Sb_2S_3$. As described in the background and the above Figs. 1 and 2, the metallization (the first collecting electrode, 2, the second collecting electrode, 3, as well as the digits 4 and 5) consisting of two interpenetrated combs has a dual role, as device contacts and grating for surface plasmon polaritons (SPP) generation. As described in Fig. 3, in this wavelength band, the chalcogenide semiconductor is transparent (extinction coefficient is equal to zero), and therefore the telecom wavelengths can be absorbed only in the metal (aluminum, here) by the so-called internal photoemission (IPE), as explained with more details in the background section of this invention. Briefly, for Schottky barrier lower than 0.75 eV, the telecom wavelengths absorbed in the aluminum, near interface with amorphous $Sb_2S_3$ will provide enough energy to the (hot) electrons located at the Fermi level, or below, to surmount the energy barrier between Al and amorphous $Sb_2S_3$ and enter the semiconductor. The enhanced evanescent electric field due to surface plasmons will accelerate the hot electrons to the opposite electrode. Thus, these hot electrons will create the photocurrent of the plasmonic detector, which is about one order of magnitude higher than in the conventional (non-plasmonic) photodetectors due to an enhanced (resonant) absorption and enhanced electric field. It is well-known by those skilled in the art that in the case of plasmonic detectors, the peak in the spectral absorption coincides with the peak in the detector photocurrent. The absorption results from Fig. 4 (a), obtained by the Rigorous Coupled Wave Analysis (RCWA) method, are evidencing a resonant absorption of the telecom wavelengths with the absorption peak shifting to red as a function of aluminum thickness increase. From Plot 41, one can notice that for an aluminum thickness equal to 230 nm, the peak of the resonant absorption is located in the telecom O band (1.26-1.36) $\mu$m. The simulation results from Fig. 4(a) were obtained for normal incidence radiation, diffraction order=1 and an aluminum grating with a periodicity P=W+S=623 nm, where the width of the metal digits, 4 and 5 is equal to 593 nm, and the space between two subsequent digits, S, is equal to 30 nm. The well-known wavelength selectivity of the plasmonic devices can be proved also here by the narrow bandwidth of the spectral absorption, which will trigger a narrow band of the spectral responsivity of the photodetector, and this will be the case for the following exemplary results from below. In addition, the lower value of the grating period (0. 623 $\mu$m) with respect to incident telecom wavelength (1.26-1.675) $\mu$m proves the subwavelength character of the photonic device, which will be obvious for the rest of the results to be described, here. Finally, the capping layer, 15, from Fig. 2 is deposited above the photodetector and it is transparent to the light from ultraviolet to mid infrared. This layer is acting as an anti-reflection coating and as a mechanical barrier against sulfur atoms loss during thermal or laser annealing

Fig. 4(b) shows the results of the numerical simulations of the absorption of the telecom wavelengths in the plasmonic interdigitated MSM Schottky hot electron photodetector, 20 described in Fig. 2 where the metal (2, 3, 4, 5) is aluminum and the semiconductor (1) is (poly)crystalline $Sb_2S_3$ film. The plasmonic detector, 20, operates as described above. The only difference between the results presented in Fig. 4 (a) and Fig. 4(b) is due to the phase transition of the $Sb_2S_3$ from the amorphous state to the (poly)crystalline state plasmonic photodetector, 20, a process which can be done either by thermal (resistive annealing) or laser annealing, as described in the background of this invention. From Fig. 4(b), one can notice that for an aluminum thickness equal to 230 nm, the peak absorption is located in the 1550 nm telecom C band (1.530-1.565) $\mu$m. The simulation results from Fig. 4(b) were obtained for normal incidence radiation, diffraction order=1 and an aluminum grating with a periodicity P=W+S=623 nm, where the width of the metal digits, 4 and 5 is equal to 593 nm, and the space between two subsequent digits, S, is equal to 30 nm.

Fig. 4 (c) shows a superposition of the resonant absorption peaks presented in Fig. 4 (a) and Fig. 4 (b), which is demonstrating very clearly the IR reconfigurability of the plasmonic interdigitated MSM hot electron Schottky photodetector, 20, from Fig. 2, when the phase change material $Sb_2S_3$ is switched between amorphous state to the (poly)crystalline state. Thus, the photodetector, 20 is detecting the telecom O band (Plot 41) in the amorphous state and the telecom C band (Plot 42) in the polycrystalline state. Unlike the prior art, where the reconfigurability was possible at the system level, by varying the temporal and spatial parameters of computer-controlled optical systems for reading the data from an array of photodetectors, here, for the first time, the reconfigurability was obtained at the device level, by reversibly switching the active PCM $Sb_2S_3$ from the amorphous to the polycrystalline state for the same photodetector.

Fig. 5(a) shows the results of the numerical simulations of the absorption of the telecom wavelengths in the reconfigurable plasmonic interdigitated MSM Schottky hot electron photodetector, 20 described in Fig. 2 where the metal (2, 3, 4, 5) is aluminum and the semiconductor (1) is amorphous $Sb_2S_3$. In Fig. 5 (a) one can notice that for an aluminum metal thickness of 240 nm, a resonant absorption of telecom E band (1.360-1.46) $\mu$m (Plot 51) can be obtained. These results are associated to an aluminum grating equal with period equal to P= 666 nm (W=636 nm, S=30 nm), normal incidence radiation and first diffraction order, m=1.

Fig. 5(b) shows the results of the numerical simulations of the absorption of the telecom wavelengths in the reconfigurable plasmonic interdigitated MSM Schottky hot electron photodetector, 20 described in Fig. 2 where the metal (2, 3, 4, 5) is aluminum and the semiconductor (1) is (poly)crystalline $Sb_2S_3$. In Fig. 5 (b) one can see that for an aluminum metal thickness of 240 nm, a resonant absorption of telecom U band (1.360-1.46) $\mu$m (Plot 52) can be obtained. These results are associated to an aluminum grating equal with period equal to P= 666 nm (W=636 nm, S=30 nm), normal incidence radiation and first diffraction order, m=1.

Fig. 5 (c) shows a superposition of the resonant absorption peaks of telecom wavelength presented in Fig. 4 (a) and Fig. 4 (b), which is demonstrating very clearly the IR reconfigurability of the plasmonic interdigitated MSM hot electron Schottky photodetector, 20, from Fig. 2, when the phase change material $Sb_2S_3$ is switched from amorphous state to the (poly)crystalline state. Thus, the photodetector, 20 is detecting the telecom O band (Plot 51) in the amorphous state and the telecom U band (Plot 52) in the polycrystalline state. These results are associated to an aluminum grating equal with period equal to P= 666 nm (W=636 nm, S=30 nm), normal incidence radiation and first diffraction order, m=1.

Comparing the results from Fig. 5 (c) and Fig. 4(c), it becomes obvious that by tunning the period of the aluminum grating from 636 nm to 666 nm, by changing the width W value of the fingers, 4 and 5, (see Fig. 2), the plasmonic photodetector can perform either the hopping from telecom C band to O band at P=636 nm, or the hopping from telecom U band to O band at P= 666 nm, when switches from polycrystalline state to amorphous state of the $Sb_2S_3$ semiconductor.

Fig. 6 shows an excellent agreement between the analytical (small dots) and the numerical simulation results (big dots) of the period of aluminum grating as a function of resonant incident IR wavelength for the case of plasmonic interdigitated MSM hot electron Schottky photodetector, 20, from Fig. 2 for the case of aluminum metallization, 2, 3, 4, 5 deposited on $Sb_2S_3$, when the semiconductor, 1, is in the (poly)crystalline state. In both theoretical cases the simulation was performed for the case of normal incidence of telecom wavelengths and the first order of diffraction, m=1. The two big dots from Fig. 6, obtained by numerical simulation, provide the values of the grating periods for which the IR photodetector, 20, from Fig. 2 are detecting the telecom C or U band, as described in Figs 4(b) and 5(b), respectively, when

the $Sb_2S_3$ semiconductor, 1, is in the (poly)crystalline state. The analytical simulation consists in the calculation of the period of grating by using the equation [3] based on matching of the momentum of incident photons with that of the grating for the case of the incidence angle equal to zero. By using the refractive index of the chemically bath deposited polycrystalline $Sb_2S_3$ from Fig. 3. (a) and the refractive index of the aluminum (https://refractiveindex.info/?shelf=3d&book=metals&page=aluminium), it was possible to find analytically the period of the grating, P=W+S, for which the momentum matching condition from equation [3] occurs at the interface between metal and $Sb_2S_3$. Thus, the generated surface plasmons polaritons will provide enhanced absorption in the metal near interface (resonant absorption) and enhanced electric field in the same region, finally enhancing the photocurrent of the detector. The added value of the numerical approach is coming from the fact that it indicates the thickness of the metal for fabrication technology and the spatial distribution of the enhanced evanescent electric field.

Fig. 7 shows also an excellent agreement between the analytical (small dots) and numerical simulation results (big dots) of the period of aluminum grating as a function of resonant incident IR wavelength for the case of plasmonic interdigitated MSM hot electron Schottky photodetector, 20, from Fig. 2 for the case of aluminum metallization, 2, 3, 4, 5 deposited on $Sb_2S_3$, when the semiconductor, 1, is in the amorphous state. In this case, the two big dots from Fig. 6, obtained by numerical simulation, provide the values of the grating periods for which the IR photodetector, 20, from Fig. 2 is detecting the telecom O or E band, as described in Figs 4(a) and 5(a), respectively, when the $Sb_2S_3$ semiconductor, 1, is in the amorphous state.

The radically new concept of reconfigurable telecom wavelength photodetector, 20, from Fig. 2, based on interdigitated plasmonic MSM, $Al/Sb_2S_3$, hot electron Schottky device, obtained when the PCM $Sb_2S_3$ material was reversibly switched from the amorphous to crystalline state, and which was proven by the numerical simulation, as shown in Figs 4(c) and Fig. 5 (c), can be also proven by the analytical modelling, as shown in Figs. 6 and 7 where the numerical results are perfectly interpolated between the analytical results of grating period versus wavelength. For example, the telecom wavelength photodetector, 20, with the grating period equal to 623 nm is detecting the telecom C band when $Sb_2S_3$ is in the polycrystalline state, as shown in Fig. 6, and the same detector (with grating period of 623 nm) is detecting the telecom O band when the $Sb_2S_3$ is in the amorphous state, as shown in Fig. 7.

Fig. 8 shows the numerical simulation results of the resonant absorption of the reconfigurable interdigitated plasmonic MSM, $Al/Sb_2S_3$, Schottky photodetector, 20, from Fig. 2, as a function of the incident visible light. The results were obtained for the case of normal incidence of light, first order of diffraction, m=1, aluminum thickness equal to 120 nm, aluminum grating period, P, equal to 169 nm, metal digits (4,5) width, W, equal to 139 nm and the interdigit spacing, S, equal to 30 nm. To better understand these results, it is necessary to consider the results presented in Fig. 3 (a) where it is shown that the extinction coefficient for amorphous and (poly)crystalline $Sb_2S_3$ film is high in the visible range. This means that the plasmonic interdigitated MSM $Al/Sb_2S_3$ Schottky photodetector, 20, from Fig. 2 is absorbing the visible light by the semiconductor. Therefore, the photons with energy higher than the bandgap will generate electron-hole pairs, which are then separated by the enhanced electric field in the depletion region of the Schottky contact, and finally generate the photocurrent. From the numerical simulation of the plasmonic photodetector, 20, with the above geometry of the metal grating, it is obtained that a resonant absorption centered on orange color (590 nm) is obtained when the $Sb_2S_3$ absorber is in the polycrystalline state (Fig. 8, Plot 82) and a resonant absorption centered on green color (540 nm) when the $Sb_2S_3$ absorber is in the amorphous state (Plot 81). Thus, it is for the first time when a reconfigurable plasmonic photodetector for the visible spectrum is disclosed, which is able to detect either a color or the other depending on the amorphous or (poly)crystalline state of the PCM $Sb_2S_3$, in this case.

Figs. 9 and 10 makes a comparison between the analytical (small dots) simulation and the numerical simulation results (big dots) of the period of aluminum grating as a function of resonant visible wavelengths for the case of reconfigurable plasmonic interdigitated MSM Schottky photodetector, 20, from Fig. 2, for the case of aluminum metallization 2, 3, 4, 5 deposited on $Sb_2S_3$ absorber (1), when this absorber is either in (poly)crystalline state (Fig. 9) or in amorphous state (Fig. 10). As mentioned before, the numerical simulation (big dots) brings a wealth of information in terms of metal thickness optimum for resonant absorption at a certain incident wavelength, as well as the profiling of the evanescent electric field at the interface between metal and semiconductor.

Figs. 11 and 12 show the results of analytical modeling and simulation of the metal grating period as a function of the incident IR wavelength (mainly the telecom band) for the case of the plasmonic interdigitated MSM hot electron Schottky $Al/Sb_2Se_3$ photodetector, 20, from Fig. 2, when the PCM $Sb_2Se_3$ chalcogenide semiconductor is either in the (poly)crystalline state (Fig. 11) or in the amorphous state (Fig. 12). The same analytical simulation methodology as described for the case of plasmonic $Al/Sb_2S_3$ Schottky photodetector was used also for the plasmonic $Al/Sb_2Se_3$ Schottky photodetector with the specification that for this situation the refractive index of PCM $Sb_2Se_3$ from Fig. 3(b) was applied. The reconfigurability of this plasmonic $Al/Sb_2Se_3$ Schottky photodetector, 20, can be again analytically demonstrated. For example, the detection of the C band (1550 nm) is performed when the PCM $Sb_2Se_3$ layer of the photodetector, 20, is in the polycrystalline state, for a period of metal grating equal to 370 nm. Now, if the $Sb_2Se_3$ semiconductor of photodetector, 20, is switched in the amorphous state, for the period equal to 370 nm, one can find an incident wavelength equal to 1260 nm (telecom O band). Similar examples of hopping from a shorter telecom wavelength (1260 nm) to a longer telecom wavelength (1550 nm) can be seen when the PCM $Sb_2Se_3$ is performing a phase transition from the amorphous to polycrystalline a phase.

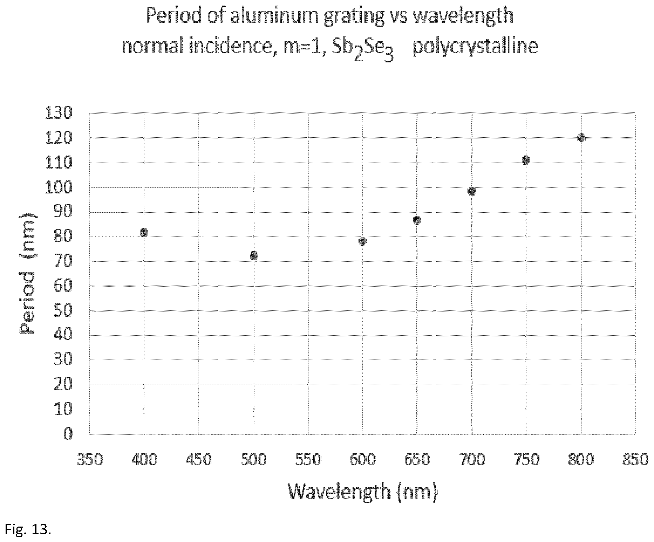

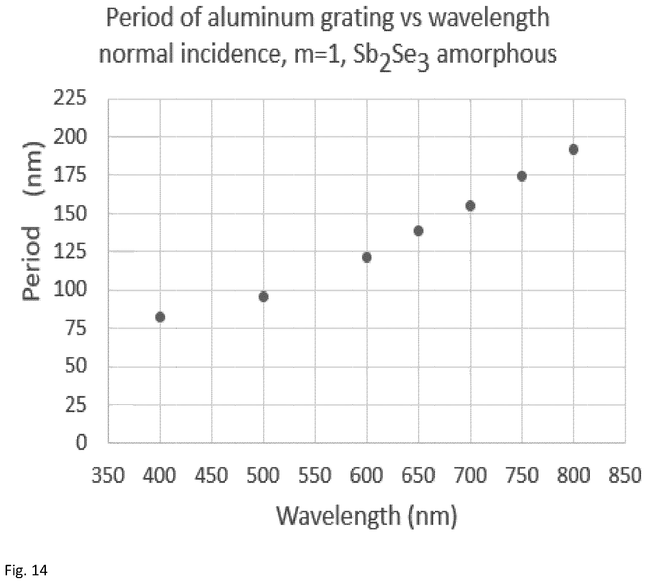

Figs. 13 and 14 show the results of analytical modeling and simulation of the metal grating period as a function of the incident visible wavelengths for the case of the plasmonic interdigitated MSM hot electron Schottky $Al/Sb_2Se_3$ photodetector, 20, from Fig. 2, when the PCM $Sb_2Se_3$ chalcogenide semiconductor is either in the (poly)crystalline state (Fig. 13) or in the amorphous state (Fig. 14). The same analytical simulation methodology as described for the case $Al/Sb_2S_3$ Schottky contact was used for $Al/Sb_2Se_3$ Schottky contact, with the specification that for this situation the refractive index of PCM $Sb_2Se_3$ from Fig. 3(b) was applied. The reconfigurability of this plasmonic $Al/Sb_2Se_3$ Schottky photodetector, 20, can be again analytically demonstrated. For example, the detection of the red color (650 nm) is performed with the PCM $Sb_2Se_3$ layer of the photodetector, 20, in the polycrystalline state, for a period of metal grating equal to 86 nm nm. Now, if the $Sb_2Se_3$ semiconductor of photodetector, 20, is switched in the amorphous state, for the period equal to 86 nm, one can find a plasmonic incident wavelength equal to 500 nm (cyan color). Such similar examples of hopping from longer wavelengths of visible light to shorter wavelengths of visible light can be identified when the PCM $Sb_2Se_3$ is performing a phase transition from the polycrystalline a phase to the amorphous one.

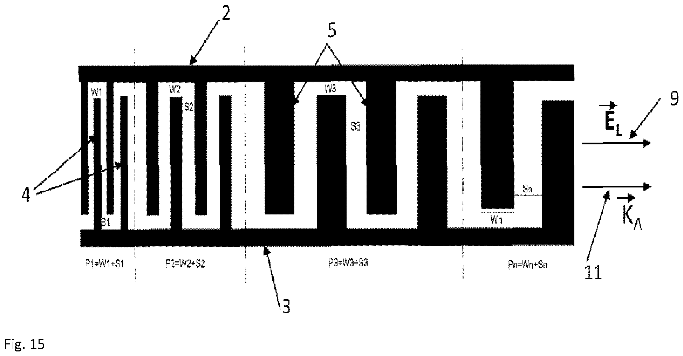

The reconfigurable plasmonic interdigitated photodetectors for the telecom wavelengths or the visible spectrum described above are wavelength-selective, as an intrinsic property of the resonant coupling of the incident light to the surface plasmon polaritons from the interface of a metal with a dielectric or semiconductor. This may create a (too) narrow bandwidth for some applications. For example, this may become obvious, if a comparison is made with the commercial $In_xGa_{1-x}As$-based IR photodetectors, which are detecting a larger wavelength band, like from 0.9 to 1.7 $\mu$m. To address this possible limitation, in Fig. 15 an example of a wideband reconfigurable plasmonic photodetector is disclosed, which consists of three individual plasmonic photodetector connected electrically in parallel. Each of the three photodetectors, from Fig. 15, has its own grating period, P1, P2 and P3, and therefore each of them will be wavelength-selective with its own bandwidth, but working together, in parallel, they will enlarge the bandwidth by the superposition of their individual bandwidths. This is one of the major advantages of the interdigitated plasmonic photodetectors, built with two collecting electrodes, 2, 3 from Figs. 1 and 2. This approach is valid for any wavelength band including the (IR) telecom wavelength plasmonic interdigitated photodetectors and the visible light photodetectors.

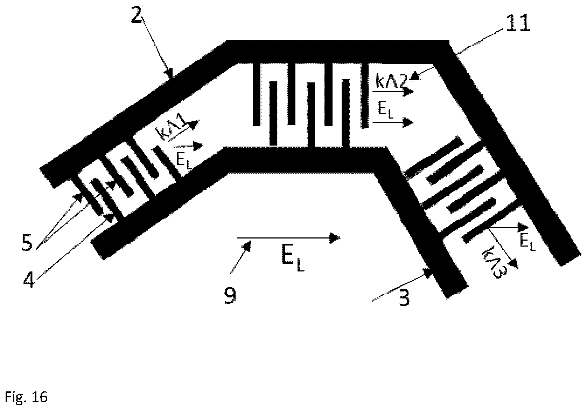

The reconfigurable plasmonic interdigitated photodetectors are polarization angle-selective, as demonstrated in the background of this invention. This means that the photocurrent is maximum only for the case of the electric field vector ($E_L$) of the **p-polarized** light parallel to the grating vector, $K_\Lambda$ (according to equation [5] from background). In Fig. 16 an innovative reconfigurable, multi-polarization, multiband, plasmonic interdigitated photodetector is disclosed, where for a certain direction of the electric field vector, $E_L$, 9, three polarization angles are shown with the three grating vectors, $K_{\Lambda1}$, $K_{\Lambda2}$, $K_{\Lambda3}$, and the total photocurrent is the sum of these three components, with the highest contribution coming from the grating $K_{\Lambda2}$ For normal incidence of the light to the surface of the photodetector, the three photodetectors electrically connected in parallel, $K_{\Lambda1}$, $K_{\Lambda2}$, $K_{\Lambda3}$ have the absorption peak at the same wavelength, if the they have the same grating period, $K_{\Lambda1} = K_{\Lambda2} = K_{\Lambda3}$. However, if the **p-polarized** light is making an incident angle, $\theta \neq 0$ with the normal to the device surface, then, according to the equation [4], the three photodetectors $K_{\Lambda1}$, $K_{\Lambda2}$, $K_{\Lambda3}$ will have different resonant absorptions (corresponding to different wavelengths), even if they have the same period of grating, $K_{\Lambda1} = K_{\Lambda2} = K_{\Lambda3}$. Thus, a reconfigurable, multi-band, multi-polarization photodetector can be obtained and disclosed here. This novel concept can be applied for either the telecom band detection, mimicking the large bandwidth of the commercial InGaAs detectors, or for wideband visible light detection by means of plasmonic interdigitated detectors electrically connected in parallel between two collecting electrodes, 2 and 3 in Fig. 2, where each metal grating with its period is tuned to a portion of the wider detection spectrum.

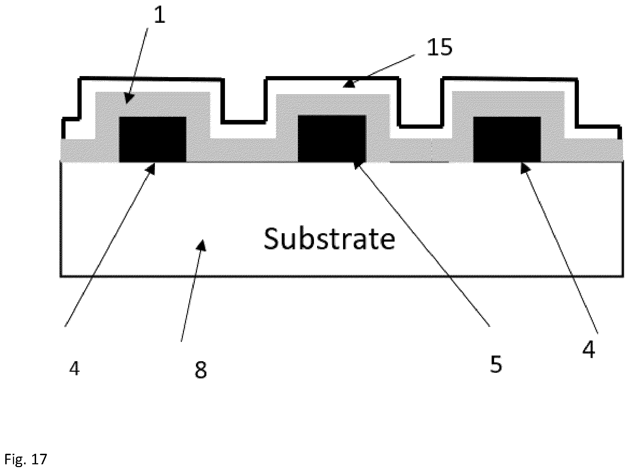

As demonstrated in the background of this invention, the quantum efficiency of the IR hot electron Schottky detectors is very low, below 2%, due to the limited number of hot electrons which have the chance to surmount the energy barrier created at the interface between a metal and a semiconductor. Under these considerations, in Fig. 17, an innovative reconfigurable plasmonic interdigitated MSM Schottky hot electron detector is shown where three interfaces metal-semiconductor are formed between the plasmonic metal digits, 4, 5, and the semiconductor PCM chalcogenide, 1. Thus, the photocurrent will increase proportionally with the number of interfaces and the associated areas. As it is obvious from this figure, in this case, the plasmonic metal (Al, Au, Ga) is deposited first on the dielectric substrate, 8, ($Si/SiO_2$, sapphire, glass) followed by the deposition of the PCM chalcogenide, 1, ($Sb_2S_3$, $Sb_2Se_3$, $Sb_2S_xSe_{3-x}$) with the thickness of 50-100 nm, and followed by the deposition of the capping layer, 15 (ZnS (20%-$SiO_2$(80%)) with the thickness of 50-100 nm. Local etching of the capping layer will be finally performed for contacting the bond pads located on the collecting electrodes, 2,3, not shown in Fig. 17. In the case of the gold deposition on the substrate, firstly, a titanium adherence layer with a thickness of 2-3 nm is deposited on the substrate, 8.

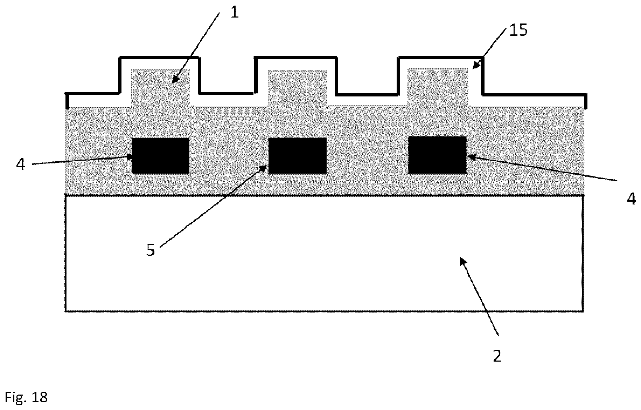

Fig. 18 shows a cross section through a further improved reconfigurable, plasmonic, interdigitated MSM Schottky hot electron photodetector, where the plasmonic metal (4,5) is fully embedded in the PCM chalcogenide semiconductor, 1, and where, the number of metal-semiconductor interfaces is equal to four. This technological configuration is maximizing the quantum efficiency of the internal photoemission (IPE) of hot electrons from the plasmonic metal, and thus a maximum photocurrent and spectral responsivity can be obtained.

The fabrication technology of the plasmonic hot electron photodetector with maximum photocurrent and spectral responsivity is obvious from Fig. 18, as follows. The first step is the chemical cleaning of the substrate, 8, consisting in degreasing the substrate by ethanol cleaning followed by a superficial etching of the substrate surface in diluted HF-deionized water solution. Then, the deposition of a first layer of PCM chalcogenide layer, 1 ($Sb_2S_3$, $Sb_2Se_3$, $Sb_2S_xSe_{3-x}$) on freshly cleaned substrate, 1, is performed. The deposition methods for the PCM chalcogenide semiconductors from above can be : chemical bath deposition, physical vapor deposition (sputtering, electron gun evaporation), atomic layer deposition, pulsed layer deposition. Immediately, a plasmonic metal (4,5) (Au/Ti, or Al or Ga) is deposited on the first layer of PCM chalcogenide semiconductor. In the case of Au layer, a titanium adherence (and barrier) layer with thickness of 2-3 nm is deposited before gold deposition. In the case of Al layer, a $Si_3N_4$ barrier layer with thickness of 2-3 nm may be deposited before Al deposition The patterning of the metal layer (photolithographic process followed by metal etching /removal) will create the interdigitated MSM geometry of the plasmonic reconfigurable MSM Schottky hot electron photodetector. For gold metallization the lift-off technology can be also used, where a photoresist mask is first created on the substrate. The metal layer is deposited on this photoresist mask. Th photoresist mask is design so that the gold portion which should be removed is deposited on the top of the photoresist mask. For gold patterning, the gold layer deposited on the photoresist is finally removed together with the photoresist substrate. After the plasmonic metal is deposited and patterned (4,5), a second layer of chalcogenide semiconductor,!, ($Sb_2S_3$, $Sb_2Se_3$, $Sb_2S_xSe_{3-x}$) is deposited above the patterned plasmonic metal (4,5). Finally, the capping layer, (ZnS(20%)-$SiO_2$(80%)), 15, is deposited on the entire processed substrate, followed by a photolithographic and etching process for removing locally the second layer of chalcogenide substrate and contact the bonding pad of the metallization.

The fabrication technology of the reconfigurable plasmonic interdigitated MSM Schottky detector for visible light spectrum can be performed following either the schematic device presentation from Figs. 1 and 2, where a single PCM semiconductor chalcogenide layer, 1, is deposited on the substrate, 8, followed by the patterned metal (2, 3, 4, 5) and the capping layer (ZnS(20%)-$SiO_2$(80%)), or the schematic cross section of the device presented in Fig. 17, where a plasmonic metal (Al, Au/Ti, Ga) is deposited and patterned first on the substrate, 8, followed by the PCM chalcogenide semiconductor, 1, ($Sb_2S_3$, $Sb_2Se_3$, $Sb_2S_xSe_{3-x}$) and capping layer deposition. The thickness of the PCM chalcogenide semiconductor is in the range of 50-100 nm, or even higher depending on application requirement.

For those skilled in the art, it is easy to further design other layouts of the reconfigurable plasmonic interdigitated Schottky photodetectors, multiband, multi-polarization able to detect more than three wavelength bands, at any polarization angles between the electric field of incident radiation and the grating vectors of those interdigitated gratings, and remain within the scope of the claim attached hereto. Therefore, it will be understood that this disclosure is, in many respects, only illustrative. Changes may be made at detail level, in arrangement of the gratings, number of gratings, shape of collecting electrodes, layout size and digits orientation with respect to collecting electrodes without exceeding the scope of the invention.

**Claims**

1. A reconfigurable plasmonic interdigitated metal-semiconductor-metal Schottky photodetector (10) comprising:

   a first collecting plasmonic metal electrode (2) containing a multitude of periodic metal digits (5), digits, parallel one to the other,
   a second collecting plasmonic metal electrode (3) containing a multitude of periodic metal digits (4), parallel one to the other and interpenetrated with the digits of the first collecting electrode, the network of all these metal digits forming an optical grating with a certain periodicity,
   a phase change chalcogenide semiconductor layer (1) in contact with the metal,
   a capping layer (15) covering the top surface of photodetector, acting as a mechanica barrier against chalcogenide atoms loss during thermal and laser annealing, and an anti-reflection coating.

2. The reconfigurable photodetector from claim 1, where the reconfigurability is obtained by the reversible transition of the chalcogenide semiconductor from the crystalline to the amorphous state and the opposite via different laser and thermal annealing.

3. The reconfigurable photodetector from claim 2, where the phase change chalcogenide semiconductor consists of one of the following materials $Sb_2S_3$, $Sb_2Se_3$, $Sb_2S_xSe_{3-x}$ and the metal is one of the plasmonic metals Al, Au/Ti, Ga.

4. The reconfigurable photodetector from claim 3 able to detect any of the telecom wavelength bands via hot electron internal photoemission by means of the proper periodicity design of the optical grating.

5. The reconfigurable photodetector from claim 4 able to perform hopping from telecom longer wavelength bands to telecom shorter wavelength bands, and the opposite when the phase change chalcogenide semiconductor has a phase transition from crystalline state to amorphous state, and the opposite.

6. The reconfigurable photodetector from claim 3, able to perform hopping from a longer wavelength of visible spectrum to a shorter wavelength of the visible spectrum, and the opposite, when the phase change chalcogenide semiconductor has a phase transition from crystalline to amorphous state, and the opposite.

7. The reconfigurable plasmonic photodetector from claim 1 able to operate as a wideband photonic device by electrically connecting multiple optical gratings in parallel, each of the grating having the same polarization angle and its own periodicity of metal digits.

8. The reconfigurable plasmonic photodetector from claim 1 able to operate as a wideband multi-polarization photonic device by electrically connecting multiple optical gratings in parallel, each of the grating having its own periodicity of metal digits and its own polarization angle between the electric field vector of p-polarized light and the grating vector.

9. A fabrication method for a reconfigurable plasmonic interdigitated metal-semiconductor-metal Schottky photodetector (10) comprising:

a first collecting plasmonic metal electrode (2), like aluminum, gold, gallium, and containing a multitude of periodic metal digits (5), parallel one to the other,
a second collecting plasmonic metal electrode (3) like aluminum, gold, gallium, and containing a multitude of periodic metal digits (4), parallel one to the other and interpenetrated with the digits of the first collecting electrode, the network of all these metal digits forming an optical grating with a certain periodicity,
a phase change chalcogenide semiconductor layer (1) from the family of $Sb_2S_3$, $Sb_2Se_3$ and $Sb_2S_xSe_{3-x}$ in contact with the metal,
a capping layer (15), like $ZnS(20\%)$-$SiO_2(80\%)$, covering the top surface of photodetector, acting as a mechanical barrier to chalcogenide atoms loss and an anti-reflection coating.

10. The method from claim 9, where the reconfigurable photodetector is processed by the following sequence: deposition of the phase change chalcogenide semiconductor layer on the dielectric substrate, followed by the deposition and patterning of the plasmonic metal, followed by the deposition and patterning of the capping layer for creating two access windows to the metallization bond pads of the detector.

11. The method from claim 9, where the reconfigurable photodetector is processed by the following sequence: deposition and patterning of the plasmonic metal layer directly on the substrate, followed by the deposition of the phase change chalcogenide semiconductor layer, followed by deposition of the capping layer, followed by the patterning and selective etching of the capping layer for creating two access windows to the metallization bond pads of the photodetector.

12. The method from claim 9, where the reconfigurable photodetector of a maximum responsivity is processed by the following sequence: deposition of the first phase change chalcogenide semiconductor layer directly on the substrate, followed by the deposition and patterning of the plasmonic metal layer, followed by the deposition of the second phase change chalcogenide semiconductor layer, covering entirely all the walls of the metal fingers, followed by the deposition and patterning of the capping layer for creating access windows to the bond pads of the two electrodes of the photodetector.

13. The fabrication method from the claim 9 where the deposition of aluminum layer on the phase change chalcogenide semiconductor is preceded by the deposition of barrier layer of $Si_3N_4$ with a thickness of 1-3 nm.

14. The fabrication method from the claim 9 where the deposition of gold layer on the phase change chalcogenide semiconductor is preceded by the deposition of barrier layer of titanium layer with a thickness of 1-3 nm.

15. The fabrication method from claim 9, where the phase transition of the phase change chalcogenide semiconductor layer is performed from amorphous state to the crystalline state by a longer laser pulse tuned on the absorption band of chalcogenide and the phase transition from the crystalline state to the amorphous state is performed by one or more short laser pulses at the same wavelength followed by film quenching.

**Patentansprüche**

1. Rekonfigurierbarer plasmonischer ineinandergreifender Metall-Halbleiter-Metall Schottky-Photodetektor (10), umfassend:

   eine erste plasmonische metallische Sammelelektrode (2), die eine Vielzahl periodischer, zueinander paralleler Metallteilen (5) enthält,
   eine zweite plasmonische metallische Sammelelektrode (3), die eine Vielzahl periodischer, zueinander paralleler Metallteilen (4) enthält, die mit den Teilen der ersten Sammelelektrode durchsetzt sind, wobei das Netzwerk all dieser Metallteile ein optisches Gitter mit einer bestimmten Periodizität bildet,
   eine Chalkogenid-Halbleiterschicht (1) mit Phasenübergang in Kontakt mit dem Metall,
   eine Deckschicht (15), welche die Oberseite des Photodetektors bedeckt und als mechanische Barriere gegen den Verlust von Chalkogenidatomen während des thermischen und Laser-Glühens wirkt, und eine Antireflexionsschicht.

2. Rekonfigurierbarer Photodetektor nach Anspruch 1, wobei die Rekonfigurierbarkeit durch den reversiblen Übergang des Chalkogenid-Halbleiters vom kristallinen zum amorphen Zustand und umgekehrt durch unterschiedliches Laser- und thermisches Glühen erreicht wird.

3. Rekonfigurierbarer Photodetektor nach Anspruch 2, wobei der Chalkogenid-Halbleiter mit Phasenübergang aus einem der folgenden Materialien besteht: $Sb_2S_3$, $Sb_2Se_3$, $Sb_2S_xSe_{3-x}$ und das Metall eines der plasmonischen Metalle Al, Au/Ti, Ga ist.

4. Rekonfigurierbarer Photodetektor nach Anspruch 3, der in der Lage ist, jedes beliebige Telekom-Wellenlängenband durch interne Photoemission heißer Elektronen zu detektieren, indem das optische Gitter mit der richtigen Periodizität ausgeführt wird.

5. Rekonfigurierbarer Photodetektor nach Anspruch 4, der in der Lage ist, einen Sprung von längeren Telekom-Wellenlängenbändern zu kürzeren Telekom-Wellenlängenbändern und umgekehrt durchzuführen, wenn der Chalkogenid-Halbleiter mit Phasenübergang einen Phasenwechsel vom kristallinen Zustand zum amorphen Zustand und umgekehrt aufweist.

6. Rekonfigurierbarer Photodetektor nach Anspruch 3, der in der Lage ist, einen Sprung von einer längeren Wellenlänge des sichtbaren Spektrums zu einer kürzeren Wellenlänge des sichtbaren Spektrums und umgekehrt durchzuführen, wenn der Chalkogenid-Halbleiter mit Phasenübergang einen Phasenwechsel vom kristallinen zum amorphen Zustand und umgekehrt aufweist.

7. Rekonfigurierbarer plasmonischer Photodetektor nach Anspruch 1, der in der Lage ist, als breitbandige photonische Vorrichtung zu arbeiten, indem mehrere optische Gitter elektrisch parallelgeschaltet werden, wobei jedes der Gitter denselben Polarisationswinkel und seine eigene Periodizität der Metallteile aufweist.

8. Rekonfigurierbarer plasmonischer Photodetektor nach Anspruch 1, der in der Lage ist, als breitbandige photonische Multipolarisationsvorrichtung zu arbeiten, indem mehrere optische Gitter elektrisch parallelgeschaltet werden, wobei jedes der Gitter seine eigene Periodizität von Metallteilen und seinen eigenen Polarisationswinkel zwischen dem elektrischen Feldvektor von p-polarisiertem Licht und dem Gittervektor aufweist.

9. Herstellungsverfahren für einen rekonfigurierbaren plasmonischen ineinandergreifenden Metall-Halbleiter-Metall Schottky-Photodetektor (10) umfassend:

   eine erste plasmonische metallische Sammelelektrode (2), z.B. aus Aluminium, Gold, Gallium, und enthaltend eine Vielzahl periodischer, zueinander paralleler Metallteilen (5),
   eine zweite plasmonische metallische Sammelelektrode (3), z.B. aus Aluminium, Gold, Gallium, und enthaltend eine Vielzahl periodischer, zueinander paralleler Metallteilen (4), die mit den Teilen der ersten Sammelelektrode durchsetzt sind, wobei das Netzwerk all dieser Metallteile ein optisches Gitter mit einer bestimmten Periodizität bildet,
   eine Chalkogenid-Halbleiterschicht (1) mit Phasenübergang aus der Familie von $Sb_2S_3$, $Sb_2Se_3$ und $Sb_2S_xSe_{3-x}$ in Kontakt mit dem Metall,
   eine Deckschicht (15), wie $ZnS(20\%)$-$SiO_2(80\%)$, welche die Oberseite des Photodetektors bedeckt und als mechanische Barriere gegen den Verlust von Chalkogenidatomen wirkt, und eine Antireflexionsschicht.

10. Verfahren nach Anspruch 9, wobei der rekonfigurierbare Photodetektor durch die folgende Sequenz verarbeitet wird: Aufbringen der Chalkogenid-Halbleiterschicht mit Phasenübergang auf dem dielektrischen Substrat, gefolgt von dem Aufbringen und Mustern des plasmonischen Metalls, gefolgt von dem Aufbringen und Mustern der Deckschicht, um zwei Zugangsfenster zu den Metallisierungsverbindungspads des Detektors zu schaffen.

11. Verfahren nach Anspruch 9, wobei der rekonfigurierbare Photodetektor durch die folgende Sequenz verarbeitet wird: Aufbringen und Mustern der plasmonischen Metallschicht direkt auf dem Substrat, gefolgt von dem Aufbringen der Chalkogenid-Halbleiterschicht mit Phasenübergang, gefolgt von dem Aufbringen der Deckschicht, gefolgt von dem Mustern und selektiven Ätzen der Deckschicht, um zwei Zugangsfenster zu den Metallisierungsverbindungspads des Photodetektors zu schaffen.

12. Verfahren nach Anspruch 9, wobei der rekonfigurierbare Photodetektor mit maximaler Empfindlichkeit durch die folgende Sequenz verarbeitet wird: Aufbringen der ersten Chalkogenid-Halbleiterschicht mit Phasenübergang direkt auf dem Substrat, gefolgt von dem Aufbringen und Mustern der plasmonischen Metallschicht, gefolgt von dem Aufbringen der zweiten Chalkogenid-Halbleiterschicht mit Phasenübergang, die alle Wände der Metallzacken vollständig bedeckt, gefolgt von dem Aufbringen und Mustern der Deckschicht, um Zugangsfenster zu den Verbindungspads der beiden Elektroden des Photodetektors zu schaffen.

13. Herstellungsverfahren nach Anspruch 9, wobei dem Aufbringen der Aluminiumschicht auf dem Chalkogenid-Halbleiter mit Phasenübergang das Aufbringen einer Barriereschicht aus $Si_3N_4$ mit einer Dicke von 1-3 nm vorausgeht.

14. Herstellungsverfahren nach Anspruch 9, wobei dem Aufbringen der Goldschicht auf dem Chalkogenid-Halbleiter mit Phasenübergang das Aufbringen einer Barriereschicht aus einer Titanschicht mit einer Dicke von 1-3 nm vorausgeht.

15. Herstellungsverfahren nach Anspruch 9, wobei der Phasenwechsel der Chalkogenid-Halbleiterschicht mit Phasenübergang vom amorphen zum kristallinen Zustand durch einen längeren, auf die Chalkogenid-Absorptionsbande abgestimmten Laserimpuls und der Phasenwechsel vom kristallinen zum amorphen Zustand durch einen oder mehrere kurze Laserimpulse derselben Wellenlänge mit anschließender Filmabschreckung erfolgt.

**Revendications**

1. Un photodétecteur Schottky métal-semiconducteur-métal interdigité plasmonique reconfigurable comprenant :

   une première électrode métallique plasmonique collectrice (2) contenant une multitude de chiffres métalliques périodiques (5), parallèles les uns aux autres,
   une seconde électrode métallique plasmonique collectrice (3) contenant une multitude de chiffres métalliques périodiques (4), parallèles les uns aux autres et interpénétrés avec les chiffres de la première électrode collectrice, le réseau de tous ces chiffres métalliques formant un réseau optique avec une certaine périodicité,
   une couche semi-conductrice de chalcogénure à changement de phase (1) en contact avec le métal,
   une couche de recouvrement (15) recouvrant la surface supérieure du photodétecteur, agissant comme une barrière mécanique contre la perte d'atomes de chalcogénure pendant le recuit thermique et laser, et un revêtement antireflet.

2. Photodétecteur reconfigurable selon la revendication 1, dans lequel la reconfigurabilité est obtenue par la transition réversible du semi-conducteur chalcogénure de l'état cristallin à l'état amorphe et à l'inverse via un recuit laser et thermique différent.

3. Photodétecteur reconfigurable selon la revendication 2, dans lequel le semi-conducteur chalcogénure à changement de phase est constitué de l'un des matériaux suivants $Sb_2S_3$, $Sb_2Se_3$, $Sb_2S_xSe_{3-x}$ et le métal est l'un des métaux plasmoniques Al, Au/Ti, Ga.

4. Le photodétecteur reconfigurable selon la revendication 3 est capable de détecter n'importe laquelle des bandes de longueurs d'onde de télécommunication via une photoémission interne d'électrons chauds au moyen de la conception de périodicité appropriée du réseau optique.

5. Le photodétecteur reconfigurable selon la revendication 4 est capable d'effectuer des sauts depuis des bandes de longueurs d'onde de télécommunication plus longues vers des bandes de longueurs d'onde de télécommunication plus courtes, et à l'inverse lorsque le semi-conducteur chalcogénure à changement de phase présente une transition de phase de l'état cristallin à l'état amorphe, et l'inverse.

6. Photodétecteur reconfigurable selon la revendication 3, capable d'effectuer un saut d'une longueur d'onde plus longue du spectre visible à une longueur d'onde plus courte du spectre visible, et l'inverse, lorsque le semi-conducteur chalcogénure à changement de phase présente une transition de phase de l'état cristallin à l'état amorphe, et l'inverse.

7. Le photodétecteur plasmonique reconfigurable selon la revendication 1 peut fonctionner comme un dispositif photonique à large bande en connectant électriquement plusieurs réseaux optiques en parallèle, chacun des réseaux ayant le même angle de polarisation et sa propre périodicité de chiffres métalliques.

8. Le photodétecteur plasmonique reconfigurable selon la revendication 1 est capable de fonctionner comme un dispositif photonique multipolarisation à large bande en connectant électriquement plusieurs réseaux optiques en parallèle, chacun des réseaux ayant sa propre périodicité de chiffres métalliques et son propre angle de polarisation entre le vecteur de champ électrique de la lumière polarisée p et le vecteur de réseau.

9. Procédé de fabrication d'un photodétecteur Schottky métal-semiconducteur-métal interdigité plasmonique reconfigurable (10) comprenant :

   une première électrode métallique plasmonique collectrice (2), de type aluminium, or, gallium, et contenant une multitude de chiffres métalliques périodiques (5), parallèles les uns aux autres,
   une seconde électrode collectrice plasmonique métallique (3) de type aluminium, or, gallium, et contenant une multitude de chiffres métalliques périodiques (4), parallèles les uns aux autres et interpénétrés avec les chiffres de la première électrode collectrice, le réseau de tous ces chiffres métalliques formant un réseau optique avec une certaine périodicité,
   une couche semi-conductrice à changement de phase de type chalcogénure (1) de la famille $Sb_2S_3$, $Sb_2Se_3$ et $Sb_2S_xSe_{3-x}$ en contact avec le métal,
   une couche de recouvrement (15), comme $ZnS(20\%)$-$SiO_2(80\%)$, recouvrant la surface supérieure du photodétecteur, agissant comme une barrière mécanique à la perte d'atomes de chalcogénure et un revêtement antireflet.

10. Procédé selon la revendication 9, dans lequel le photodétecteur reconfigurable est traité par la séquence suivante : dépôt de la couche semi-conductrice de chalcogénure à changement de phase sur le substrat diélectrique, suivi du dépôt et de la structuration du métal plasmonique, suivi du dépôt et de la structuration de la couche de recouvrement pour créer deux fenêtres d'accès aux plots de liaison de métallisation du détecteur.

11. Procédé selon la revendication 9, dans lequel le photodétecteur reconfigurable est traité par la séquence suivante: dépôt et structuration de la couche métallique plasmonique directement sur le substrat, suivi du dépôt de la couche semi-conductrice de chalcogénure à changement de phase, suivi du dépôt de la couche de recouvrement, suivi de la structuration et de la gravure sélective de la couche de recouvrement pour créer deux fenêtres d'accès aux plots de liaison de métallisation du photodétecteur.

12. Procédé selon la revendication 9, dans lequel le photodétecteur reconfigurable à sensibilité maximale est traité par la séquence suivante : dépôt de la première couche semi-conductrice à changement de phase chalcogénure directement sur le substrat, suivi du dépôt et de la structuration de la couche métallique plasmonique, suivi du dépôt de la seconde couche semi-conductrice à changement de phase chalcogénure, recouvrant entièrement toutes les parois des doigts métalliques, suivi du dépôt et de la structuration de la couche de recouvrement pour créer des fenêtres d'accès aux plots de liaison des deux électrodes du photodétecteur.

13. Procédé de fabrication selon la revendication 9, dans lequel le dépôt d'une couche d'aluminium sur le semi-conducteur à chalcogénure à changement de phase est précédé du dépôt d'une couche barrière de $Si_3N_4$ d'une épaisseur de 1 à 3 nm.

14. Procédé de fabrication selon la revendication 9, dans lequel le dépôt d'une couche d'or sur le semi-conducteur à chalcogénure à changement de phase est précédé du dépôt d'une couche barrière de couche de titane d'une épaisseur de 1 à 3 nm.

15. Procédé de fabrication selon la revendication 9, dans lequel la transition de phase de la couche semi-conductrice de chalcogénure à changement de phase est réalisée de l'état amorphe à l'état cristallin par une impulsion laser plus longue accordée sur la bande d'absorption du chalcogénure et la transition de phase de l'état cristallin à l'état amorphe est réalisée par une ou plusieurs impulsions laser courtes à la même longueur d'onde suivies d'une trempe du film.

Fig. 1

7 → ☼ Light source

2

5

4

3

6
Ⓥ

10

1

8

20

2

7

a)

A ──── W ──────── A'

S

6
Ⓥ

9

k_Λ

E_L

5

4

3

11

15

b)

1

8

Fig. 2

Fig. 3

Fig. 4 (a)

Fig. 4 (b)

Fig. 4 (c).

Fig. 5 (a).

Fig. 5 (b)

Fig. 5 (c)

Fig. 6.

Fig. 7

Fig. 8.

Fig. 9.

Fig. 10.

Fig. 11.

Fig. 12

Period of aluminum grating vs wavelength
normal incidence, m=1, $Sb_2Se_3$ polycrystalline

Fig. 13.

Period of aluminum grating vs wavelength normal incidence, m=1, $Sb_2Se_3$ amorphous

Fig. 14

Fig. 15

Fig. 16

1

15

Substrate

4          8                              5          4

Fig. 17

EP 4 287 277 B1

Fig. 18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6819469 B
- US 5625729 A
- US 7026701 B2
- US 20110175183 A1

- US 11112305 B2
- US 20200144437 A1
- US 7106374 B1

**Non-patent literature cited in the description**

- **B. HUANG ; J. ROBERTSON.** Bonding origin of optical contrast in phase-change memory materials. *PHYSICAL REVIEW B,* 2010, vol. 81, 081204
- **T. OHTA.** Phase-Change Optical Memory Promotes The DVD Optical Disk. *Journal of Optoelectronics and Advanced Materials,* September 2001, vol. 3 (3), 609-626
- **PENGFEI GUO ; ANDREW M. SARANGAN ; IMAD AGHA.** A Review of Germanium-Antimony-Telluride Phase Change Materials for Non-Volatile Memories and Optical Modulators. *Appl. Sci.,* 2019, vol. 9, 530
- **XINGZHE SHI ; CHANGSHUI CHEN ; SONGHAO LIU ; GUANGYUAN LI.** Nonvolatile, reconfigurable and narrowband mid-infrared filter based on surface lattice resonance in phase-change GeSbTe. *Nanomaterials,* 2020, vol. 10, 2530
- **GHOLIPOUR, B. ; ZHANG, J. ; MACDONALD, K.F. ; HEWAK, D.W. ; ZHELUDEV, N.I.** An all-optical, non-volatile, bidirectional, phase-change meta-switch. *Adv. Mater.,* 2013, vol. 25, 3050-3054
- **SARANGAN, A. ; DURAN, J. ; VASILYEV, V. ; LIMBEROPOULOS, N. ; VITEBSKIY, I. ; ANISIMOV, I.** Broadband Reflective Optical Limiter Using GST Phase Change Material. *IEEE Photonics J.,* 2018, vol. 10, 1-9
- **SIEBER, P.E. ; WERNER, D.H.** Reconfigurable broadband infrared circularly polarizing reflectors based on phase changing birefringent metasurfaces. *Opt. Express,* 2013, vol. 21, 1087-1100
- **YAEL GUTIERREZ ; ANNA P. OVVYAN ; GONZALO SANTOS ; DILSON JUAN ; SAUL A. ROSALES ; JAVIER JUNQUERA ; PABLO GARCIA FERNANDEZ ; STEFANO DICORATO ; MARIA M. GIANGREGORIO ; ELENA DILONARDO.** Interlaboratory Study Unveiling the Correlation between Structure and Dielectric Function of Sb2S3 and its Amorphous-to-Crystalline Phase Change and Potential Applications. *ISCIENCE-D,* 2022

- **YIFEI ZHANG ; JEFFREY B. CHOU ; JUNYING LI ; HUASHAN LI ; QINGYANG DU ; ANUPAMA YADAV ; SI ZHOU ; MIKHAIL Y. SHALAGINOV ; ZHUORAN FANG ; HUIKAI ZHONG.** Broadband transparent optical phase change materials for high-performance nonvolatile photonics. *NATURE COMMUNICATIONS,* 2019, www.nature.com/naturecommunications
- **AGOSTINO PIROVANO ; ANDREA L. LACAITA ; AUGUSTO BENVENUTI ; FABIO PELLIZZER ; ROBERTO BEZWHICH.** Electronic Switching in Phase-Change Memories. *IEEE TRANSACTIONS ON ELECTRON DEVICES,* March 2004, vol. 51 (3
- **MÜLLER, M.J. ; YADAV, A. ; PERSCH, C. ; WAHL, S. ; HOFF, F. ; WUTTIG, M.** Tailoring Crystallization Kinetics Chalcogenides for Photonic Applications. *Adv. Electron. Mater.,* 2021, 2100974, https://doi.org/10.1002/aelm.202100974
- **DONG, W. ; LIU, H. ; BEHERA, J.K. ; LU, L. ; NG, R.J.H. ; SREEKANTH, K.V. ; ZHOU, X. ; YANG, J.K.W. ; SIMPSON, R.E.** Wide Bandgap Phase Change Material Tuned Visible Photonics. *Adv. Funct. Mater.,* 2019, vol. 29, 1806181
- **P. ARUN ; A. VEDESHWAR ; N. MEHRA.** Laser-induced crystallization in amorphous films of Sb2C3 (C = S, Se, Te), potential optical storage media. *J. Phys. D. Appl. Phys.,* 1999
- **DELANEY, M. ; ZEIMPEKIS, I. ; LAWSON, D. ; HEWAK, D.W. ; MUSKENS, O.L.** A New Family of Ultralow Loss Reversible Phase-Change Materials for Photonic Integrated Circuits: Sb2 S3 and Sb2Se. *Adv. Funct. Mater.,* 2020, vol. 30, 2002447, https://doi.org/10.1002/adfm.202002447
- **DAVID V. TSU ; TAKEO OHTA.** Mechanism of properties of noble ZnZ-SiO2 protection layer for phase change optical disk media. *Jpn. J. Appl. Phys.,* 2006, vol. 45, 6294

- **SARAH MESSINA ; M.T.S NAIR ; K. NAIR.** Antimony sulfide thin films in chemically deposited thin film photovoltaic cells. *Thin Solid Films,* 2007, vol. 515, 5777-5782
- **COBIANU, C. ; GHEORGHE, M. ; MODREANU, M. ; GUTIERREZ, Y. ; LOSURDO, M.** Chemically Bath Deposited Sb2S3, Films as Optical Phase Change Materials. *2021 International Semiconductor Conference (CAS). IEEE,* 2021, 249-252, https://doi.org/10.1109/CAS52836.2021.9604155
- **GUTIERREZ, Y. ; FERNÁNDEZ, A. ; ROSALES, S. ; COBIANU, C. ; GHEORGHE, M. ; MODREANU, M. ; SAIZ, J. ; MORENO, F. ; LOSURDO, M.** 2022. Polarimetry Analysis and Optical Contrast of Sb2S3 Phase Change Material. *Opt. Materials Express,* April 2022, vol. 12 (4 / 1), 1531-1541, https://doi.org/10.1364/OME.450781
- **DONG, W. ; LIU, H. ; BEHERA, J.K. ; LU, L. ; NG, R.J.H. ; SREEKANTH, K.V. ; ZHOU, X. ; YANG, J.K.W. ; SIMPSON, R.E.** 2019. Wide Bandgap Phase Change Material Tuned Visible Photonics. *Adv. Funct. Mater.,* vol. 29, 1806181
- **DELANEY, M. ; ZEIMPEKIS, I. ; LAWSON, D. ; HEWAK, D.W. ; MUSKENS, O.L.** 2020. A New Family of Ultralow Loss Reversible Phase-Change Materials for Photonic Integrated Circuits: Sb2 S3 and Sb2Se3. *Adv. Funct. Mater,* vol. 30, 2002447, https://doi.org/10.1002/adfm.202002447
- **YAEL GUTIERREZ ; ANNA P. OVVYAN ; GONZALO SANTOS ; DILSON JUAN ; SAUL A. ROSALES ; JAVIER JUNQUERA ; PABLO GARCIA FERNANDEZ ; STEFANO DICORATO ; MARIA M. GIANGREGORIO ; ELENA DILONARDO.** Interlaboratory Study Unveiling the Correlation between Structure and Dielectric Function of Sb2S3 and its Amorphous-to-Crystalline Phase Change and Potential Applications. *ISCIENCE-D,* 2022
- **DELANEY, M. ; ZEIMPEKIS, I. ; LAWSON, D. ; HEWAK, D.W. ; MUSKENS, O.L.** 2020. A New Family of Ultralow Loss Reversible Phase-Change Materials for Photonic Integrated Circuits: Sb2S3 and Sb2Se3. *Adv. Funct. Mater.,* vol. 30, 2002447
- **JING WANG ; SAJID URREHMAN ; YANG XU ; BINZHOU ZUO ; HAOHANG CHENG ; LINGSHAN GUO ; BIN ZOU ; XIAOMING ZHANG ; CHUANBO LI.** Two-dimensional antimony selenide (Sb2Se3) nanosheets prepared by hydrothermal method for visible-light photodetectors. *Solar Energy,* February 2022, vol. 233, 213-220
- **C. GENET ; T.W. EBESSEN.** *Light in tiny holes, Nature Reviews,* 04 January 2007, vol. 445
- **W. BEINSTINGL ; E. GORNIK.** Polarization sensitive surface plasmon Schottky detectors. *Optics Letters,* 15 July 1989, vol. 14 (14), 719-721
- **T.W. EBBESEN ; H.J.LEZEC ; H.F. GHAEMI ; T. THIO ; P.A. WOLFF.** Extraordinary optical transmission through sub-wavelength hole array. *Nature,* 12 February 1998, vol. 391, 667-669
- **BETH H.A.** Theory of diffraction by small holes. *Phys. Rev.,* 1946, vol. 66, 163-182
- **C. GENET ; T.W. EBBESEN.** Light in tiny holes. *Nature Reviews,* 04 January 2007, vol. 445
- **S.R.J. BRUECK ; V. DIADIUK ; T. JONES ; W. LENTH.** Enhanced quantum efficiency internal photoemission detectors by grating coupling to the surface plasma waves. *Appl. Phys. Letters,* 15 May 1985, vol. 46 (10), 915-917
- **ALI SOBHANI et al.** Narrow band photodetection in the near-infrared with a plasmon-induced hot electron device. *Nature Communications,* 2013
- **S.M. SZE ; D.J. COLEMAN JR ; A. LOYA.** Current transport in Metal-Semiconductor-Metal (MSM) structures. *Solid State Electronics,* 1971, vol. 14, 1209-1218
- **JULIAN B.D. SOOLE ; HERMANN SCHUMACHER.** InGaAs Metal-Semiconductor-Metal Photodetectors for Long Wavelength optical communication. *IEEE Journal of Quantum Electronics,* March 1991, vol. 27 (3
- **M. ZHONG ; X. WANG ; S. LIU ; B. LI ; L. HUANG ; Y. CUI ; J. LI ; Z. WEI.** High performance photodetector based on Sb2S3 nanowire: wavelength dependence and wide temperature range utilization. *Nanoscale, Nanoscale,* 2017, vol. 9, 12364-12371
- **GUTIERREZ, Y. ; FERNÁNDEZ, A. ; ROSALES, S. ; COBIANU, C. ; GHEORGHE, M. ; MODREANU, M. ; SAIZ, J. ; MORENO, F. ; LOSURDO, M.** 2022. Polarimetry Analysis and Optical Contrast of Sb2S3 Phase Change Material. *Opt. Materials Express,* April 2022, vol. 12 (4 / 1), 1531-1541, https://doi.org/10.1364/QME.450781
- **DELANEY, M. ; ZEIMPEKIS, I. ; LAWSON, D. ; HEWAK, D.W. ; MUSKENS, O.L.** A New Family of Ultralow Loss Reversible Phase-Change Materials for Photonic Integrated Circuits: Sb2 S3 and Sb2Se3. *Adv. Funct. Mater.,* 2020, vol. 30, 2002447, https://doi.org/10.1002/adfm.202002447